(19)

Europäisches
Patentamt
European
Patent Office
Office européen
des brevets

(11)  **EP 3 139 406 A1**

(12)  **EUROPEAN PATENT APPLICATION**
published in accordance with Art. 153(4) EPC

(43) Date of publication:
08.03.2017 Bulletin 2017/10

(21) Application number: **15785624.6**

(22) Date of filing: **24.04.2015**

(51) Int Cl.:
*H01L 21/8234* (2006.01)  *H01L 21/28* (2006.01)
*H01L 21/336* (2006.01)  *H01L 21/822* (2006.01)
*H01L 27/04* (2006.01)  *H01L 27/06* (2006.01)
*H01L 27/088* (2006.01)  *H01L 29/78* (2006.01)
*H02J 7/02* (2016.01)

(86) International application number:
**PCT/JP2015/002221**

(87) International publication number:
**WO 2015/166654 (05.11.2015 Gazette 2015/44)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **01.05.2014 JP 2014094346**
**27.05.2014 JP 2014108634**

(71) Applicant: **Panasonic Intellectual Property
Management Co., Ltd.
Osaka-shi, Osaka 570-6207 (JP)**

(72) Inventors:
• **YASUDA, Eiji**
**1-61, Shiromi 2-chome, Chuo-ku,
Osaka-shi
Osaka 540-6207 (JP)**

• **OTSUJI, Michiya**
**1-61, Shiromi 2-chome, Chuo-ku,
Osaka-shi
Osaka 540-6207 (JP)**
• **MASADA, Atsuya**
**1-61, Shiromi 2-chome, Chuo-ku,
Osaka-shi
Osaka 540-6207 (JP)**
• **TAGUCHI, Masahide**
**1-61, Shiromi 2-chome, Chuo-ku,
Osaka-shi
Osaka 540-6207 (JP)**

(74) Representative: **Grünecker Patent- und
Rechtsanwälte
PartG mbB
Leopoldstraße 4
80802 München (DE)**

(54)  **SEMICONDUCTOR DEVICE AND SEMICONDUCTOR MODULE**

(57)    To achieve a reduced number of components mounted on a printed wiring board, and a reduced mounting area of components. A MOSFET semiconductor device according to the present invention includes a transistor as a plurality of semiconductor layers formed in a semiconductor substrate, and includes a source electrode, a gate electrode, a drain electrode, and a gate insulating film. The MOSFET semiconductor device further includes an insulating film formed on a first principal surface of the semiconductor substrate, a resistance film formed on the insulating film and electrically connected with the drain electrode, and a resistance electrode formed on the resistance film and serving as a surface mount terminal. With this configuration, reduction can be achieved in the number of components mounted on the printed wiring board, and hence in the mounting area of the components, and heat generating in the resistance film can be transferred to the printed wiring board to prevent malfunction of a MOSFET due to heat.

FIG. 5

EP 3 139 406 A1

**Description**

TECHNICAL FIELD

The present invention relates to a metal-oxide-semiconductor field-effect transistor (MOSFET) type semiconductor device and a semiconductor module that are used as a cell balance circuit of a charging circuit configured to charge a plurality of batteries.

BACKGROUND ART

When a plurality of secondary batteries are connected in series in a charge and discharge circuit of a secondary battery such as a lithium ion battery, the individual secondary batteries have variation in their battery voltages in some cases. Such variation in the battery voltages of the secondary batteries leads to overdischarge and overcharge in some secondary batteries, resulting in degradation of the secondary batteries.

In order to reduce such variation in the battery voltages of secondary batteries, NPL 1 discloses a circuit in which a MOSFET and a resistor are connected in parallel with the individual secondary battery. In this circuit, when the battery voltage of the individual secondary battery becomes equal to or larger than a predetermined voltage, the MOSFET connected with the secondary battery is controlled to be turned on. When the MOSFET is turned on, the secondary battery connected with the MOSFET is discharged through the resistor, and the battery voltage decreases accordingly. This allows adjustment of a balance between the battery voltages of a plurality of the secondary batteries, and to prevent overcharge and overdischarge of the secondary batteries, and hence degradation thereof. The resistor sets a discharge current value of each secondary battery through its resistance.

When the MOSFET is turned on, the resistor connected with the MOSFET generates heat. Thus, with a configuration in which the resistor and the MOSFET are disposed close to each other, the heat generated by the resistor potentially causes malfunction of the MOSFET. In order to prevent this malfunction, in the circuit disclosed in NPL 1, the resistor and the MOSFET are separately mounted as individual components on a printed wiring board.

When a battery, or a battery cell (hereinafter simply referred to as a battery) included in the battery is charged, the batteries are connected in series, and then voltage is applied to the batteries connected in series to boost each battery to a predetermined voltage. When the batteries connected in series are charged, and the charging is continued without being stopped each time one battery reaches a predetermined voltage while each cell being charged has a voltage different from voltages of other cells, the battery becomes overcharged. In order to charge all batteries to a predetermined voltage, provided is a cell balance circuit configured to stop charging and discharge a cell each time any one of the batteries reaches the predetermined voltage. The cell balance circuit stops charging each time one battery reaches a predetermined voltage while a plurality of batteries are charged, and discharges only this battery under control of the cell balance circuit until a constant voltage is reached. Thereafter, the cell balance circuit again performs charging, and repeats charging and discharging until all batteries reach the predetermined voltage. In this manner, the cell balance circuit performs charging of all batteries until the batteries reach the predetermined voltage without overcharge of any battery.

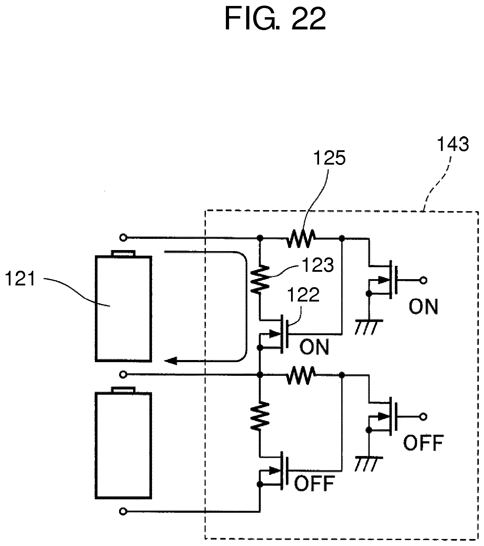

The following describes the cell balance circuit and a charging circuit including the cell balance circuit with reference to FIG. 22.

FIG. 22 is a diagram illustrating a schematic configuration of a charging circuit including the cell balance circuit.

As illustrated in FIG. 22, the charging circuit includes a plurality of batteries 121 connected in series, and cell balance circuit 143 configured to apply voltage to batteries 121 and prevent overcharge of batteries 121. Cell balance circuit 143 includes MOSFET 122 connecting positive and negative terminals of each battery 121 and configured to discharge battery 121, a control circuit configured to control an operation of MOSFET 122, discharge resistor 123 configured to determine a discharge current and convert the discharge current into heat, and chip resistance 125 configured to prevent application of overcurrent to MOSFET 122.

Cell balance circuit 143 with such a configuration stops charging each time one battery 121 is charged up to a predetermined voltage, and turns on MOSFET 122 connected with battery 121 under control of the control circuit to discharge battery 121 to a constant voltage. After discharging to the constant voltage, cell balance circuit 143 turns off MOSFET 122 to stop discharging and starts charging of batteries 121 connected in series. This operation is repeated until all of batteries 121 are charged to the predetermined voltage. In this manner, all of batteries 121 are charged to the predetermined voltage while being prevented from overcharge.

Citation List

Patent Literature

PTL 1: Unexamined Japanese Patent Publication No. 2007-85847

Non-Patent Literature

NPL1: Toranjisuta gijutsu(Transistor Technology) (January 2014), CQ Publishing Co., Ltd., January 1, 2014, pp. 62 to 64

## SUMMARY OF THE INVENTION

### TECHNICAL PROBLEM

However, in a protection circuit disclosed in NPL 1, one resistor is needed for one MOSFET, and thus the number of components mounted on a printed wiring board increases, leading to a larger mounting area occupying the printed wiring board. In recent years, reduction has been required in the size and weight of a semiconductor component, and thus it is important to solve the above problem. In particular, in a component mounted on an automobile requiring a higher reliability than other commercial products, an increased number of connections between components by, for example, soldering leads to an increased number of soldering failure at the connections, which is degradation of reliability. Although the components are required to be incorporated in a semiconductor device, when a resistor in the above-described protection circuit is incorporated into a semiconductor device with high integration of elements, a shorter distance between a MOSFET and the resistor as a heat source adversely causes malfunction of the MOSFET due to heat generated in the resistor.

In addition, recently, a shorter time has been required for charging of a battery, and for example, a time taken for discharging in cell balance circuit 143 in FIG. 22 is required to be shortened. In order to shorten the time taken for discharging, the discharge current needs to be increased by reducing a resistance of discharge resistor 123.

However, the reduction in the resistance of discharge resistor 123 leads to an increase in a generated heat amount. In other words, the generated heat amount is proportional to an electric power consumption P, which is determined by Expression (1) below.

$$P = IV = I(IR) = I^2R \ ... \ (1)$$

In the expression, I represents a current value [A] of the discharge current, and R represents a resistance [Ω] of the discharge resistor.

According to Expression (1), a larger discharge current leads to a larger generated heat amount. Then, a larger generated heat amount thermally affects battery 121 and its surrounding circuits, and in particular, causing fire on battery 121, which is a problem in safety. For this reason, a rise in temperature needs to be reduced, but the reduction of the temperature rise requires reduction in the discharge current by increasing the resistance of discharge resistor 123. The reduction in the discharge current to achieve a larger resistance of discharge resistor 123, however, adversely results in degradation of discharging efficiency. Thus, in cell balance circuit 143, the discharging efficiency and the generated heat amount have a trade-off relation therebetween.

## SOLUTION TO PROBLEM

The present invention intends to solve the above-described problem, and it is an object of the present invention to prevent malfunction of a MOSFET by reducing a number of components mounted on a printed wiring board to achieve a smaller mounting area of the components, to achieve improved discharging efficiency by reducing a resistance of a discharge resistor at low temperature, and to reduce a generated heat amount by increasing the resistance at higher temperature.

A semiconductor device in which a discharge switch MOSFET of a cell balance circuit used for a charging circuit configured to charge a plurality of batteries is integrated on a semiconductor substrate further includes a discharge resistor integrated on the semiconductor substrate, and a resistance electrode integrated on the discharge resistor. The discharge resistor includes a first terminal surface connected with a drain terminal of the MOSFET, a second terminal surface connected with the resistance electrode, and an insulation surface insulating between the first terminal surface and the second terminal surface. The first terminal surface is electrically connected with the drain terminal of the MOSFET. The second terminal surface is in contact with and electrically connected with the resistance electrode in an entire region of an upper surface of the discharge resistor except for the first terminal surface and the insulation surface. When the semiconductor device is mounted on a component mounting surface of a mount substrate on which the cell balance circuit is mounted, with an upper surface of the semiconductor device facing to the component mounting surface, the resistance electrode is jointed to a terminal joint on the component mounting surface of the mount substrate through a joint material allowing electric conduction, and when one of the plurality of batteries is discharged, both terminals of the battery are electrically connected with the resistance electrode and a source terminal of the MOSFET, respectively, and conduction between the drain terminal and the source terminal of the MOSFET is controlled.

A semiconductor device in which a discharge switch MOSFET of a cell balance circuit used for a charging circuit configured to charge a plurality of batteries is integrated on a semiconductor substrate further includes a discharge resistor integrated the semiconductor substrate. One of terminals of the discharge resistor is connected with a drain terminal of the MOSFET. A resistance of the discharge resistor has a positive temperature dependency. When one of the plurality of batteries is discharged, both terminals of the battery are electrically connected with the other terminal of the discharge resistor and a source terminal of the MOSFET, respectively, and conduction between a drain terminal and the source terminal of the MOSFET is controlled.

## ADVANTAGEOUS EFFECTS OF INVENTION

According to a MOSFET semiconductor device of the present invention, the MOSFET and a resistance film serving as a resistor are formed in one semiconductor device, thereby achieving reduction in a number of components as compared to a case in which these are separately mounted as individual components on a printed wiring board, and hence achieving reduction in a mounting area of the components.

A resistance electrode of the semiconductor device is a surface mount terminal, and the semiconductor device is flip-mounted on the printed wiring board by using a joint material, a terminal surface connected with a resistance electrode of a discharge resistor is in contact with the resistance electrode in an entire region of the terminal surface except for a terminal surface connected with a drain terminal, and an insulation surface, so as to provide a larger contact area for more efficient thermal conduction of heat generated in the resistance film. Accordingly, the heat generated in the resistance film is radiated to the printed wiring board through the resistance electrode. The resistance electrode, the joint material, and the printed wiring board are made of a metal having a high thermal conductivity to further increase heat radiation efficiency. This can prevent malfunction of the MOSFET due to the heat.

Moreover, incorporation of a resistor and a diode in a semiconductor module into the semiconductor device can achieve a reduced number of connections between components in the semiconductor module by, for example, soldering. In particular, a reduced failure rate can be achieved for a component mounted on an automobile requiring a higher reliability than other commercial products.

In addition, the MOSFET and the discharge resistor are integrated on one chip, and the discharge resistor is provided with a positive temperature dependency, so that a larger resistance of the discharge resistor can be achieved at a higher temperature, and reduction in a generated heat amount can also be achieved in the discharge resistor, so as to prevent a high temperature of the circuit. The discharge resistor has a smaller resistance at low temperature, which leads to an increased discharge current, so that this achieves improved discharging efficiency.

## BRIEF DESCRIPTION OF DRAWINGS

FIG. 1 is a diagram illustrating a semiconductor module on which a MOSFET semiconductor device according to a first exemplary embodiment of the present invention is mounted.
FIG. 2 is a diagram illustrating a connection part of the MOSFET semiconductor device and the semiconductor module according to the first exemplary embodiment of the present invention.
FIG. 3 is a diagram illustrating a connection part of another MOSFET semiconductor device and the semiconductor module according to the first exemplary embodiment of the present invention.
FIG. 4 is a plan view of the MOSFET semiconductor device according to the first exemplary embodiment of the present invention.
FIG. 5 is a sectional view of the MOSFET semiconductor device according to the first exemplary embodiment of the present invention taken along line II-II in FIG. 4.
FIG. 6 is an equivalent circuit diagram of the MOSFET semiconductor device according to the first exemplary embodiment of the present invention.
FIG. 7 is a diagram illustrating an exemplary application of the MOSFET semiconductor device according to the first exemplary embodiment of the present invention.
FIG. 8 is a diagram illustrating an operation of the MOSFET semiconductor device according to the first exemplary embodiment of the present invention.
FIG. 9 is a sectional view of a modification of the MOSFET semiconductor device according to the first exemplary embodiment of the present invention.
FIG. 10 is a diagram illustrating a method of manufacturing the MOSFET semiconductor device according to the first exemplary embodiment of the present invention.
FIG. 11 is a plan view of a modification of the MOSFET semiconductor device according to the first exemplary embodiment of the present invention.
FIG. 12 is a sectional view of the modification of the MOSFET semiconductor device according to the first exemplary embodiment of the present invention taken along line III-III in FIG. 11, illustrating an operation of the modification.
FIG. 13 is a sectional view of a modification of the MOSFET semiconductor device according to the first exemplary embodiment of the present invention.
FIG. 14 is a sectional view of a modification of the MOSFET semiconductor device according to the first exemplary embodiment of the present invention.
FIG. 15 is a sectional view of a configuration of a semiconductor device according to a second exemplary embodiment of the present invention.
FIG. 16 is a diagram illustrating temperature dependency of a resistance in a discharge resistor according to the second exemplary embodiment of the present invention.
FIG. 17 is a diagram illustrating a configuration of a cell balance circuit according to the second exemplary embodiment of the present invention.
FIG. 18 is a sectional view of a configuration of a semiconductor device according to a third exemplary embodiment of the present invention.
FIG. 19 is a sectional view of a configuration of a semiconductor device according to a fourth exemplary embodiment of the present invention.

FIG. 20 is a diagram illustrating a configuration of a cell balance circuit including a P-channel transistor according to a fifth exemplary embodiment of the present invention.

FIG. 21 is a diagram illustrating a configuration of a cell balance circuit including an additional component according to a sixth exemplary embodiment of the present invention.

FIG. 22 is a diagram illustrating a schematic configuration of a charging circuit including a cell balance circuit according to the background technology.

FIG. 23 is a diagram illustrating a configuration of the cell balance circuit according to the sixth exemplary embodiment of the present invention.

FIG. 24 is a plan view of a MOSFET semiconductor device according to the sixth exemplary embodiment of the present invention.

FIG. 25 is a sectional view of the MOSFET semiconductor device according to the sixth exemplary embodiment of the present invention taken along line III-III in FIG. 24.

FIG. 26 is a diagram illustrating an operation of the MOSFET semiconductor device according to the sixth exemplary embodiment of the present invention.

FIG. 27 is a sectional view of the MOSFET semiconductor device according to the sixth exemplary embodiment of the present invention taken along line III-III in FIG. 24.

FIG. 28 is a diagram illustrating the operation of the MOSFET semiconductor device according to the sixth exemplary embodiment of the present invention.

DESCRIPTION OF EMBODIMENTS

FIRST EXEMPLARY EMBODIMENT

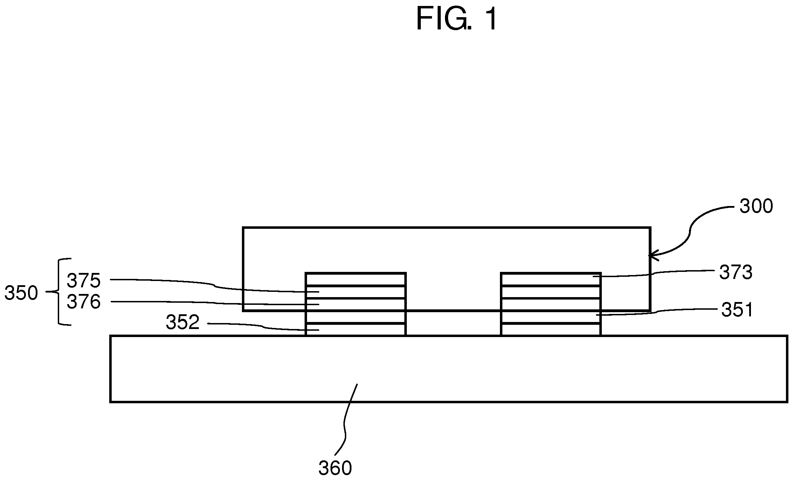

The following describes, with reference to FIGS. 1 to 3, connection between a MOSFET semiconductor device and a printed wiring board (mount substrate) in a semiconductor module on which the MOSFET semiconductor device is mounted according to the present first exemplary embodiment. The semiconductor module is a product form in which the MOSFET semiconductor device is integrally mounted on the printed wiring board. FIG. 1 illustrates an example in which a semiconductor device that is a ball grid array (BGA) chip size package is surface-mounted on a printed wiring board. As illustrated in FIG. 1, semiconductor device 300 on which surface mount terminal 350 is mounted is vertically inverted so that printed wiring board 360 on which a cell balance circuit is mounted faces to a surface on which surface mount terminal 350 is mounted. Then, the semiconductor device is mounted on the printed wiring board by jointing copper wiring (terminal joint) 352 of a connection terminal on a surface (component mounting surface) of printed wiring board 360 on which a component is mounted, and surface mount terminal (resistance electrode) 350 of semiconductor device 300 by using solder (joint material) 351.

A land grid array (LGA) chip size package may be used in place of the BGA chip size package.

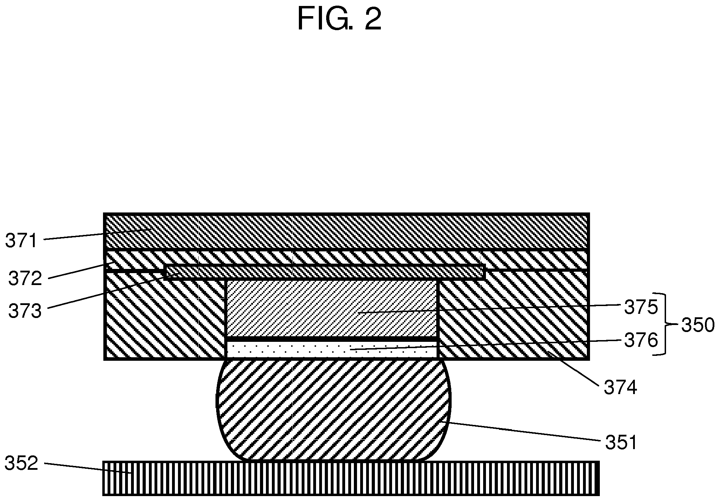

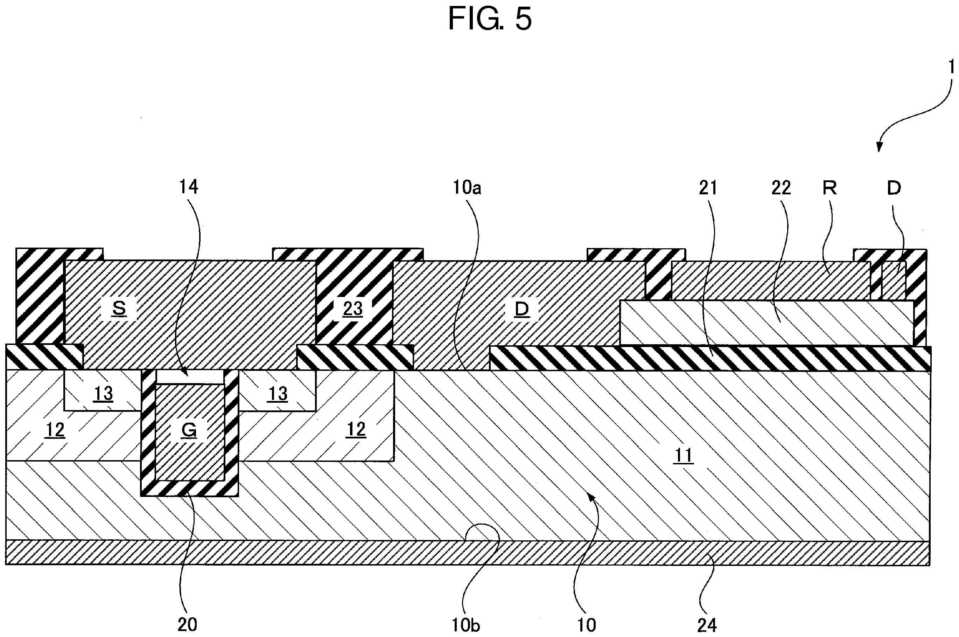

FIG. 2 is an enlarged view of a connection part in FIG. 1. FIG. 2 corresponds to FIG. 5 to be described later, and does not illustrate details of semiconductor device 300. Semiconductor device 300 is vertically inverted. Insulating film 372, resistance film 373, and surface mount terminal 350 are formed in this order below semiconductor substrate 371. A shape of resistance film 373 in plan view is not limited to a circle including an ellipse but is a polygon.

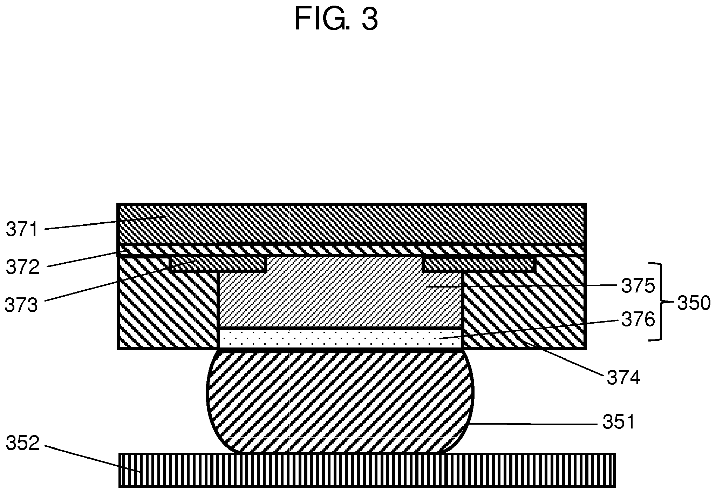

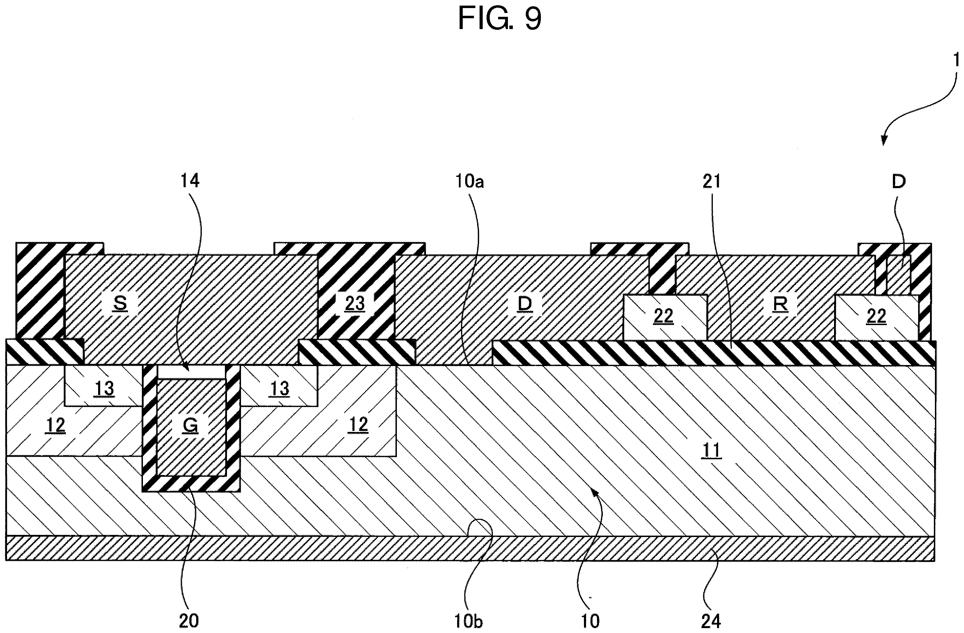

Similarly to FIG. 2, FIG. 3 is an enlarged view of the connection part in FIG. 1, and corresponds to FIG. 9 according to the first exemplary embodiment to be described later. The shape of resistance film 373 in plan view is not limited to a circle including an ellipse but is a polygonal ring.

Circumference of resistance film 373 is covered by insulating film 374. A partial region including a region at a central part of resistance film 373 is exposed from insulating film 374, and in contact with surface mount terminal 350. Surface mount terminal 350 includes, on a side closer to the semiconductor device, aluminum layer 375 formed by aluminum sputtering on a resistance film, and nickel layer 376 formed as a lowermost layer by plating.

Semiconductor device 300 is mounted on printed wiring board 360 by jointing nickel layer 376 and copper wiring 352 of a connection terminal on printed wiring board 360 by soldering.

With the above-described configuration, a discharge resistor used for the cell balance circuit is integrated as a resistance film with the semiconductor device. Accordingly, a number of components of the cell balance circuit mounted on the printed wiring board, and thus a mounting area of the components can be reduced, and heat generated in resistance film 373 is radiated through surface mount terminal 350, solder 351, and printed wiring board 360. With this configuration, for example, a distance between the discharge resistor and the printed wiring board can be reduced and an area of a heat radiation path can be increased as compared to a configuration in which nickel layer 376 and copper wiring 352 connected through a wire. When material such as metal having a high thermal conductivity is used for an electrode and a joint material on the heat radiation path, heat generated in the discharge resistor can be efficiently transferred through the printed wiring board. This can prevent malfunction of the MOSFET due to heat.

Examples of a material of solder 351 include, but are is not limited to, Sn-Pb based material, Pb-Sn-Sb based material, Sn-Sb based material, Sn-Pb-Bi based material, Bi-Sn based material, Sn-Cu based material, Sn-Pb-Cu based material, Sn-In based material, Sn-Ag based material, Sn-Pb-Ag based material, and Pb-Ag based material. A material of copper wiring 352 is not limited to copper, iron, nickel, gold, aluminum, and alloys thereof.

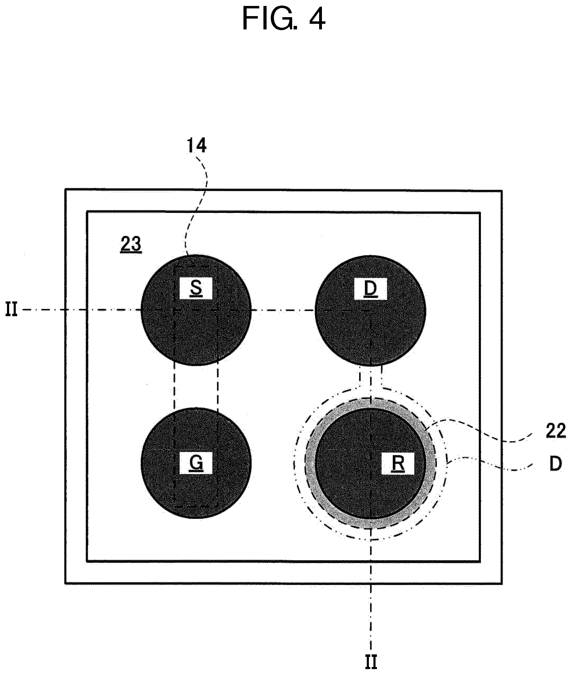

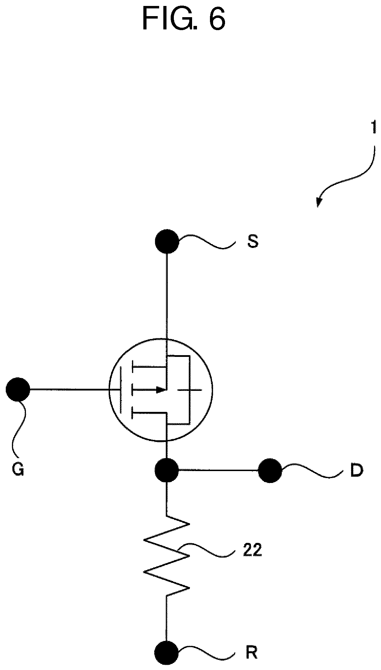

The following describes the MOSFET semiconductor device according to the present first exemplary embodiment with reference to FIGS. 4 to 6. FIG. 4 is a plan view of the MOSFET semiconductor device according to the first exemplary embodiment of the present invention. FIG. 5 is a sectional view taken along line II-II in FIG. 4. FIG. 6 is an equivalent circuit diagram of the MOSFET semiconductor device according to the first exemplary embodiment of the present invention. As illustrated in FIGS. 4 and 5, the MOSFET semiconductor device 1 according to the present first exemplary embodiment includes semiconductor substrate 10, source electrode S, gate electrode G, drain electrode D, resistance electrode R, gate insulating film 20, insulating film 21, resistance film (discharge resistor) 22, protection film 23, and metal film 24. P-type semiconductor layer 11, N-type diffusion layer 12, P-type diffusion layer 13, and trench 14 are formed in semiconductor substrate 10. Semiconductor substrate 10, source electrode S, gate electrode G, drain electrode D, and gate insulating film 20 serve as a MOSFET. Specifically, this MOSFET is a vertical MOSFET having a trench structure.

First principal surface 10a refers to a surface of semiconductor substrate 10 facing to the printed wiring board when MOSFET semiconductor device 1 according to the present first exemplary embodiment is mounted on the printed wiring board (mount substrate), and second principal surface 10b refers to another surface of semiconductor substrate 10 opposite to first principal surface 10a. Source electrode S, gate electrode G, drain electrode D, and insulating film 21 are formed on first principal surface 10a of semiconductor substrate 10. Resistance film 22 serving as a resistor is formed on insulating film 21, and resistance electrode R is formed on resistance film 22. Although FIGS. 1 to 3 illustrate the semiconductor device while first principal surface 10a facing to the printed wiring board is placed on a lower side, FIG. 5 and the following drawings illustrate the semiconductor device while first principal surface 10a is placed on an upper side.

Specifically, source electrode S, gate electrode G, drain electrode D, and resistance electrode R are formed on a side closer to first principal surface 10a, and thus are terminals to be jointed when the semiconductor device is flip-mounted on the printed wiring board at surface mounting. Thus, MOSFET semiconductor device 1 can be mounted on the printed wiring board by, for example, reflow without using a wire or the like.

Resistance film 22 is directly connected with drain electrode D. As illustrated in FIGS. 5 and 6, drain electrode D is electrically connected with resistance electrode R through resistance film 22.

In semiconductor substrate 10, P-type semiconductor layer 11, N-type diffusion layer 12, and P-type diffusion layer 13 are formed in a region below source electrode S in this order in a direction from second principal surface 10b toward first principal surface 10a, and only P-type semiconductor layer 11 is formed in a region below drain electrode D and insulating film 21. Since insulating film 21 is disposed between resistance film 22 and P-type semiconductor layer 11, P-type semiconductor layer 11 and resistance film 22 are electrically insulated.

As illustrated in FIG. 5, trench 14 of semiconductor substrate 10 is formed extending from first principal surface 10a to P-type semiconductor layer 11 through P-type diffusion layer 13 and N-type diffusion layer 12. As illustrated in FIG. 4, trench 14 is formed to have a length extending, in plan view, from a region of semiconductor substrate 10 in which gate electrode G is formed to a region below source electrode S.

Gate insulating film 20 is formed on an inner surface of trench 14, and gate electrode G is formed further inside gate insulating film 20. In other words, gate electrode G faces N-type diffusion layer 12 to interpose gate insulating film 20 therebetween.

Protection film 23 has openings such that source electrode S, gate electrode G, drain electrode D, and resistance electrode R are at least partially exposed from protection film 23 and covers a surface of the MOSFET semiconductor device on the side closer to first principal surface 10a. For example, as illustrated in FIG. 4, source electrode S, gate electrode G, drain electrode D, and resistance electrode R are each exposed in a circle from protection film 23 on the side closer to first principal surface 10a of semiconductor substrate 10.

Metal film 24 is a metal member having a low resistance and formed on second principal surface 10b of semiconductor substrate 10, and functions to conduct, to drain electrode D at high energy efficiency, current flowing from source electrode S toward second principal surface 10b of semiconductor substrate 10.

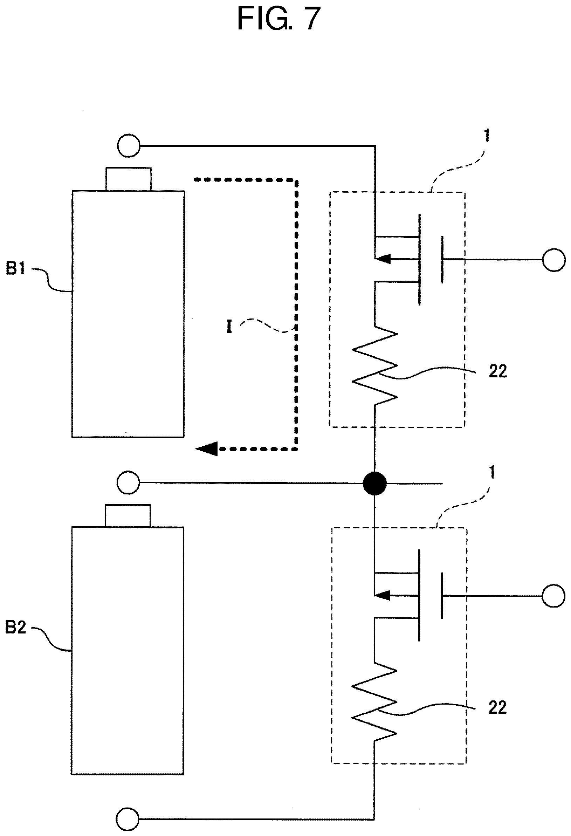

FIG. 7 illustrates an exemplary application of MOSFET semiconductor device 1 according to the present first exemplary embodiment, that is a circuit in which MOSFET semiconductor device 1 according to the present first exemplary embodiment is connected in parallel with a circuit including two secondary batteries B1 and B2 connected in series with each other.

For example, when secondary battery B1 has a battery voltage equal to or higher than a predetermined voltage, such a control is performed to turn on the MOSFET of MOSFET semiconductor device 1 connected with secondary battery B1. When the MOSFET is turned on, secondary battery B1 is discharged through resistance film 22 serving as a resistor, and the battery voltage of secondary battery B1 decreases accordingly. When secondary battery B2 has a battery voltage lower than the predetermined voltage, such a control is performed to turn off a MOSFET connected with secondary battery B2. When the MOSFET is turned off, secondary battery B2 is not discharged through resistance film 22 but is charged through a charging circuit not illustrated. In this manner, only one of two secondary batteries B1 and B2 can be charged by controlling turning on and off of the two MOSFETs.

This configuration allows adjustment of balance of battery voltage, and prevention of overcharge and overdischarge of secondary batteries B1 and B2 to further prevent degradation of the secondary batteries. When two secondary batteries or more are connected in series with each other, the individual secondary batteries may be each connected in parallel with MOSFET semiconductor device 1 according to the present first exemplary embodiment depending on this number of the secondary batteries. When the MOSFET connected with secondary battery B1 is turned on, current I flows from a positive terminal of secondary battery B1 to a negative terminal of secondary battery B1 through the MOSFET and resistance film 22. Current I has a current value determined by a resistance of resistance film 22.

In MOSFET semiconductor device 1 according to the present first exemplary embodiment, the MOSFET including semiconductor substrate 10, source electrode S, gate electrode G, drain electrode D, and gate insulating film 20, and resistance film 22 serving as a resistor are formed in one semiconductor device. With this configuration, the number of components and hence the mounting area of the components can be reduced as compared to a case in which these are separately mounted as individual components on the printed wiring board.

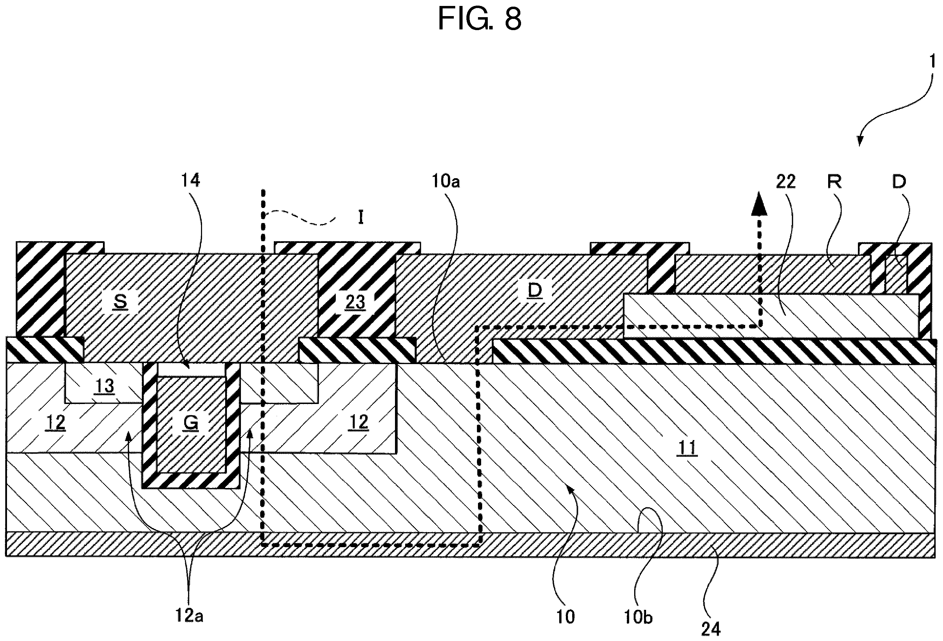

The following describes an operation of the MOSFET semiconductor device according to the present first exemplary embodiment with reference to FIG. 8. As illustrated in FIG. 8, when voltage is applied to gate electrode G, inversion layer 12a is formed in N-type diffusion layer 12 near trench 14. Then, current I in source electrode S flows to drain electrode D through P-type diffusion layer 13, inversion layer 12a, P-type semiconductor layer 11, metal film 24, and P-type semiconductor layer 11.

As described above, drain electrode D is electrically connected with resistance electrode R through resistance film 22. Thus, current I in drain electrode D flows to resistance electrode R through resistance film 22. Then, since resistance electrode R is a surface mount terminal, heat generated by current I passing through resistance film 22 is radiated toward the printed wiring board through resistance electrode R. Accordingly, this prevents malfunction of the MOSFET when being heated.

As illustrated in FIGS. 4 and 5, resistance electrode R is formed in a partial region (second terminal surface connected with the resistance electrode) on resistance film 22, and drain electrode D is formed to include a region surrounding the partial region. Drain electrode D formed in the region (first terminal surface connected with a drain terminal of the MOSFET) surrounding the partial region on resistance film 22 is preferably formed around resistance electrode R while being separated from resistance electrode R by, for example, an insulating film (insulation surface). In other words, resistance film 22 is formed to be larger than resistance electrode R along an entire circumference in plan view. Drain electrode D is not only formed in contact with first principal surface 10a but also formed on part of resistance film 22 out of resistance electrode R. Drain electrode D formed on the part of resistance film 22 out of resistance electrode R is formed around resistance electrode R while being separated from resistance electrode R. In this case, current flowing from drain electrode D to resistance electrode R through resistance film 22 flows into drain electrode D formed around resistance electrode R through a current path wide in all directions, and thus heat generated in resistance film 22 can be efficiently radiated through resistance electrode R in all directions. According to an aspect of the semiconductor device of the present invention, the terminal surface connected with the resistance electrode may be in contact with and electrically connected with the resistance electrode in an entire region of the terminal surface except for the terminal surface connected with the drain terminal of the MOSFET on an upper surface of the discharge resistor, and the insulation surface. The entire circumference, the all directions, and the entire region do not necessarily need to be continuous, but drain electrode D only needs to be formed to have a wide current path between drain electrode D and resistance electrode R.

FIG. 9 is a sectional view of a modification of the MOSFET semiconductor device according to the first exemplary embodiment of the present invention. As illustrated in FIG. 9, resistance film 22 is shaped in a ring, and may be in contact with resistance electrode R along the entire circumference. In other words, resistance film 22 has an opening at its central part, and resistance electrode R is in contact with an entire circumference of an upper surface of resistance film 22 and an entire circumference of a side surface inside the opening of resistance film 22. In this case, too, the current flowing from drain electrode D to resistance electrode R through resistance film 22 flows from drain electrode D formed around resistance electrode R through the current path wide in all directions, and thus the heat generated in resistance film 22 can be efficiently radiated through resistance electrode R in all directions. Since resistance electrode R is in contact with the entire circumference of the side surface inside the opening of resistance film 22, the radiation can be performed more efficiently.

According to an aspect of the semiconductor device of the present invention, the insulating film separating drain electrode D and resistance electrode R from each other may cover not only the upper surface of resistance film 22 but also part of a side surface of resistance film 22.

In addition, resistance film 22 preferably has a circular shape because the current between drain electrode D and resistance electrode R flows in uniformly in all directions, and thus the heat can be more efficiently dispersed. The circular shape is a circular disk shape when resistance film 22 has no opening as illustrated in FIG. 5, and is a circular ring shape when the resistance film is shaped in a ring having the opening as illustrated in FIG. 9.

According to an aspect of the semiconductor device of the present invention, the shape of the resistance film in plan view is not limited to a circular shape including an ellipse but may be a polygonal shape.

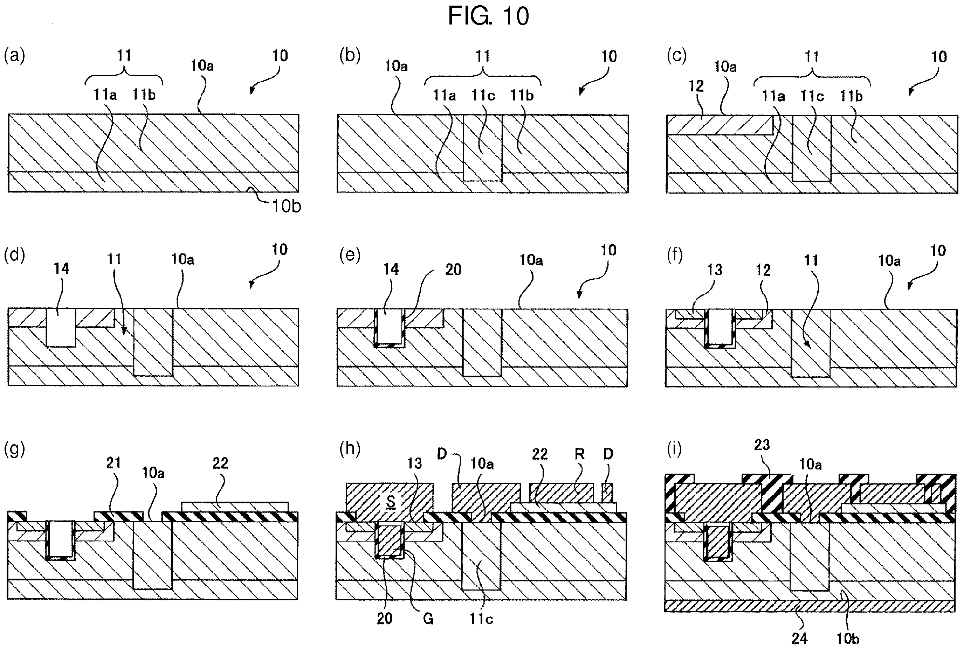

The following describes a method of manufacturing the MOSFET semiconductor device according to the first exemplary embodiment of the present invention with reference to FIG. 10. First, as illustrated in FIG. 10(a), semiconductor substrate 10 having an entire region of which is P-type semiconductor layer 11 is prepared. In the present first exemplary embodiment, P++ silicon layer 11 a is used, and one of the surfaces of P++ silicon layer 11 a is epitaxially grown to obtain P-type epitaxially grown layer 11b. With this configuration, P-type semiconductor layer 11 has a two-layer structure of P++ silicon layer 11 a and P-type epitaxially grown layer 11 b. First principal surface 10a refers to a surface of semiconductor substrate 10 closer to P-type epitaxially grown layer 11 b, and second principal surface 10b refers to an opposite surface of semiconductor substrate 10.

Then, as illustrated in FIG. 10(b), ion implantation of boron is performed in part of first principal surface 10a of semiconductor substrate 10, where the drain electrode is to be formed, and drive-in diffusion is performed to form P+ diffusion layer 11c. Accordingly, P-type semiconductor layer 11 has a three-layer structure of P++ silicon layer 11a, P-type epitaxially grown layer 11b, and P+ diffusion layer 11c. P+ diffusion layer 11c is provided to move, back to the side closer to first principal surface 10a, current flowing toward second principal surface 10b, and is required to have a low resistance to reduce an on-resistance of the MOSFET. A high doping concentration of boron can achieve a low resistance of P+ diffusion layer 11 c.

Next, as illustrated in FIG. 10(c), N-type diffusion layer 12 is formed in part of first principal surface 10a of semiconductor substrate 10, where the source electrode is to be formed. Specifically, N-type diffusion layer 12 can be formed in the part of first principal surface 10a of semiconductor substrate 10, where the source electrode is to be formed, by performing ion implantation of phosphorus into first principal surface 10a of semiconductor substrate 10 while part other than the part in which the source electrode is to be formed is covered by masking.

Thereafter, as illustrated in FIG. 10(d), trench 14 is formed in part of first principal surface 10a of semiconductor substrate 10, where gate electrode is to be formed. Specifically, the formation is performed by, for example, dry etching. Trench 14 is formed so as to extend across N-type diffusion layer 12 and P-type semiconductor layer 11, in other words, a bottom surface of trench 14 is in contact with P-type semiconductor layer 11.

Then, as illustrated in FIG. 10(e), gate insulating film 20 is formed on an inner surface of trench 14. Specifically, an oxide film is formed as gate insulating film 20 by thermally oxidizing the inner surface of the trench.

Next, as illustrated in FIG. 10(f), P-type diffusion layer 13 is formed in part of first principal surface 10a of semiconductor substrate 10, where the source electrode is to be formed. Specifically, previously formed N-type diffusion layer 12 is inverted by ion implantation of boron in the part to become P-type diffusion layer 13. An amount of ion implantation of boron needs to have been adjusted to invert N-type diffusion layer 12. In addition, P-type diffusion layer 13 needs to be set not to reach a region of P-type semiconductor layer 11.

Then, as illustrated in FIG. 10(g), insulating film 21 is formed by providing openings at parts of first principal surface 10a of semiconductor substrate 10, where the source electrode, the gate electrode, and the drain electrode are to be formed. Specifically, insulating film 21 is formed by thermally oxidizing the openings of first principal surface 10a of semiconductor substrate 10. Then, resistance film 22 is formed on insulating film 21. Specifically, a polycrystalline silicon film is formed as resistance film 22 by chemical vapor deposition (CVD).

Thereafter, as illustrated in FIG. 10(h), gate electrode G is formed inside gate insulating film 20, source electrode S is formed on P-type diffusion layer 13 of semiconductor substrate 10, drain electrode D is formed on P+ diffusion layer 11c and resistance film 22, and resistance electrode R is formed on resistance film 22. In this process, drain electrode D needs to be formed to achieve electrical connection through resistance film 22. Each electrode is made of, for example, aluminum, and may be formed by sputtering or the like.

Finally, as illustrated in FIG. 10(i), protection film 23 is formed on a predetermined part of first principal surface 10a of semiconductor substrate 10, and metal film 24 is formed on entire second principal surface 10b of semiconductor substrate 10 opposite to first principal surface 10a. Protection film 23 is formed to have openings so that source electrode S, gate electrode G, drain electrode D, and resistance electrode R are at least partially exposed from protection film 23. Specifically, protection film 23 may be formed by application, and metal film 24 may be formed by evaporation coating with a metal such as aluminum.

With this configuration, resistance film 22 serving as a resistor is formed in a process of manufacturing the semiconductor device, which eliminates a need to separately prepare a resistor, and achieves a reduced cost as compared to the conventional manufacturing method. In addition, since resistance film 22 is formed in the process of manufacturing the semiconductor device, a resistance can be accurately controlled as compared to the conventional resistor.

Since resistance film 22 is formed between drain electrode D and resistance electrode R, which are surface mount terminals, and a resistance between drain electrode D and resistance electrode R is equivalent to the resistance of resistance film 22, the resistance of resistance film 22 can be measured easily.

In the MOSFET semiconductor device and the method of manufacturing the MOSFET semiconductor device according to the present first exemplary embodiment, the MOSFET including semiconductor substrate 10, source electrode S, gate electrode G, drain electrode D, and gate insulating film 20, and resistance film 22 serving as a resistor are formed in one semiconductor device, and thus the number of components and hence the mounting area of the components can be reduced as compared to the case in which these are separately mounted as individual components on the printed wiring board.

Since drain electrode D is electrically connected with resistance electrode R through resistance film 22, current flowing into drain electrode D flows to resistance electrode R through resistance film 22. Then, since resistance electrode R is a surface mount terminal, heat generated by current I passing through resistance film 22 is radiated toward the printed wiring board through resistance electrode R. Accordingly, this prevents malfunction of the MOSFET when being heated.

In the present first exemplary embodiment, P-type semiconductor layer 11, N-type diffusion layer 12, and P-type diffusion layer 13 are formed on semiconductor substrate 10, but all of these channels may be inverted. Specifically, an N-type semiconductor layer, a P-type diffusion layer, and an N-type diffusion layer may be used in place of P-type semiconductor layer 11, N-type diffusion layer 12, and P-type diffusion layer 13, respectively, according to the present first exemplary embodiment.

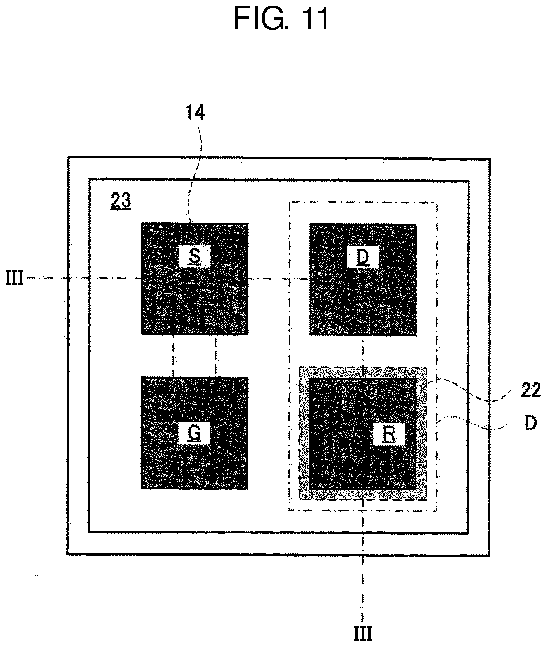

FIG. 11 is a plan view of another modification of the MOSFET semiconductor device according to the first exemplary embodiment of the present invention. In the present first exemplary embodiment, source electrode S, gate electrode G, drain electrode D, and resistance electrode R are each exposed in a circular shape from protection film 23, but the present invention is not limited thereto, and these electrodes may be each exposed in, for example, a rectangular shape, as illustrated in FIG. 11.

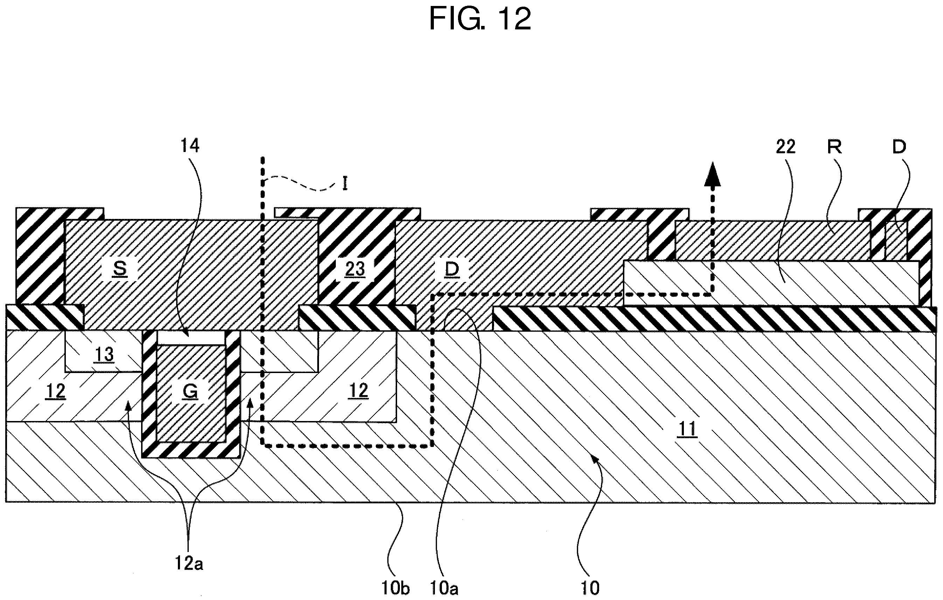

FIG. 12 is a sectional view of the modification of the MOSFET semiconductor device according to the first exemplary embodiment of the present invention taken along line III-III in FIG. 11, illustrates an operation of the modification. In the MOSFET semiconductor device according to the present first exemplary embodiment, and the process of the method of manufacturing the same illustrated in FIG. 10(i), metal film 24 is formed on second principal surface 10b of semiconductor substrate 10, but the metal film may not be formed. In such a case, when voltage is applied to gate electrode G, as illustrated in FIG. 12, the current in source electrode S flows to resistance electrode R through P-type diffusion layer 13, inversion layer 12a, P-type semiconductor layer 11, drain electrode D, and resistance film 22.

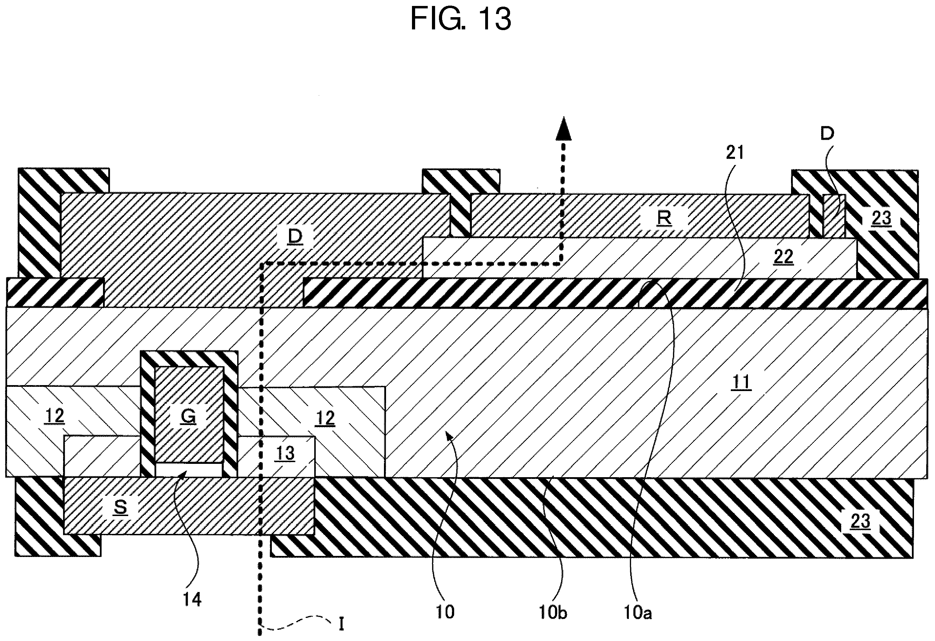

For example, FIG. 13 is a sectional view of another modification of the MOSFET semiconductor device according to the first exemplary embodiment of the present invention. In the MOSFET semiconductor device illustrated in FIG. 13, drain electrode D and resistance electrode R are formed on first principal surface 10a of semiconductor substrate 10 to provide a surface mount terminal, whereas source electrode S and gate electrode G are formed on second principal surface 10b. P-type diffusion layer 13, N-type diffusion layer 12, and P-type semiconductor layer 11 are formed in this order in a region between source electrode S and drain electrode D in semiconductor substrate 10 in the direction from second principal surface 10b toward first principal surface 10a. Trench 14 is formed across P-type diffusion layer 13, N-type diffusion layer 12, and P-type semiconductor layer 11 from second principal surface 10b of semiconductor substrate 10. Since each electrode is formed on both of first principal surface 10a and second principal surface 10b, protection film 23 is formed on both of these surfaces. In this case, when voltage is applied to gate electrode G, an inversion layer is formed in N-type diffusion layer 12 near trench 14, and current I in source electrode S flows to resistance electrode R through P-type diffusion layer 13, the inversion layer of N-type diffusion layer 12, P-type semiconductor layer 11, drain electrode D, resistance film 22.

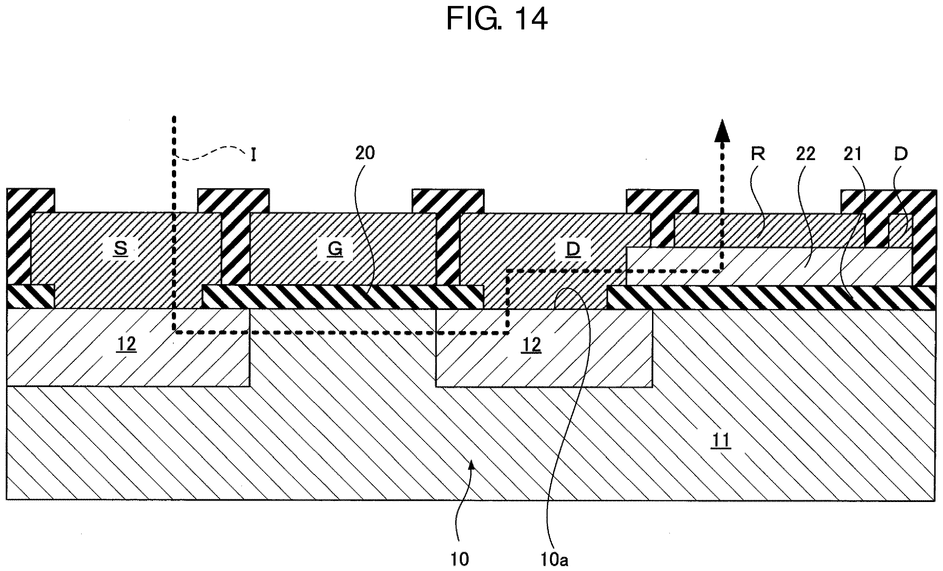

In the present first exemplary embodiment, the vertical MOSFET having a trench structure is used, but the present invention is not limited thereto, the MOSFET may have a planar or lateral structure. For example, FIG. 14 is a sectional view of another modification of the MOSFET semiconductor device according to the first exemplary embodiment of the present invention. In the MOSFET semiconductor device illustrated in FIG. 14, source electrode S, drain electrode D, gate insulating film 20, and insulating film 21 are formed on first principal surface 10a, gate electrode is formed on gate insulating film 20, resistance film 22 is formed on insulating film 21, and resistance electrode R is formed on resistance film 22. In semiconductor substrate 10, N-type diffusion layer 12 and P-type semiconductor layer 11 are formed in this order in a region below source electrode S and drain electrode D in the direction from second principal surface 10b toward first principal surface 10a, and P-type semiconductor layer 11 is formed in a region below gate insulating film 20 and insulating film 21. However, channels of P-type semiconductor layer 11 and N-type diffusion layer 12 may be inverted. P-type diffusion layer 13 and trench 14 are not formed. In this case, when voltage is applied to gate electrode G, an inversion layer is formed in P-type semiconductor layer 11 right below gate insulating film 20, and current I in source electrode S flows to resistance electrode R through N-type diffusion layer 12, the inversion layer of P-type semiconductor layer 11, N-type diffusion layer 12, drain electrode D, resistance film 22.

In the present first exemplary embodiment, source electrode S, gate electrode G, drain electrode D, and resistance electrode R are each a surface mount terminal, but the present invention is not limited thereto, and at least resistance electrode R needs to be a surface mount terminal.

In the present first exemplary embodiment, single source electrode S, single gate electrode G, single drain electrode D, and single resistance electrode R are formed, but the present invention is not limited thereto. A plurality of source electrodes S, gate electrodes G, drain electrodes D, and resistance electrodes R may be formed depending on a source-drain current value and a resistance of a resistor for stabilizing this current value.

SECOND EXEMPLARY EMBODIMENT

In the cell balance circuit, the semiconductor device of the present invention is configured as an integration of a switching semiconductor element such as a MOSFET and a discharge resistor on one chip. The discharge resistor is made of polysilicon (polycrystalline silicon film), and provided with a positive temperature dependency by adjusting a dose amount of impurity ions of implanted into polysilicon, and this dependency is adjusted. A resistance of typical polysilicon has a negative temperature dependency or slight temperature dependency. The implantation of impurity ion such as boron into polysilicon provides a positive temperature dependency to the resistance of polysilicon, and a gradient of the dependency can be adjusted through an implantation amount. In this manner, the discharge resistor is adjusted to have a low resistance at low temperature, and a high resistance at high temperature. Accordingly, a large discharge current is provided due to the low resistance at low temperature, and achieves improved discharging efficiency, and a generated heat amount can be reduced due to the high resistance at high temperature. Accordingly, this prevents a high temperature of the circuit.

The discharge resistor is provided on a drain side of the semiconductor element, and thus is preferably formed to be adjacent to the drain terminal of the semiconductor element. The discharge resistor is not limited to polysilicon, but may be a diffusion resistor with an adjusted impurity concentration.

The following describes an example in which the semiconductor element is a MOSFET in the semiconductor device of the present invention and the method of manufacturing the semiconductor device with reference to drawings.

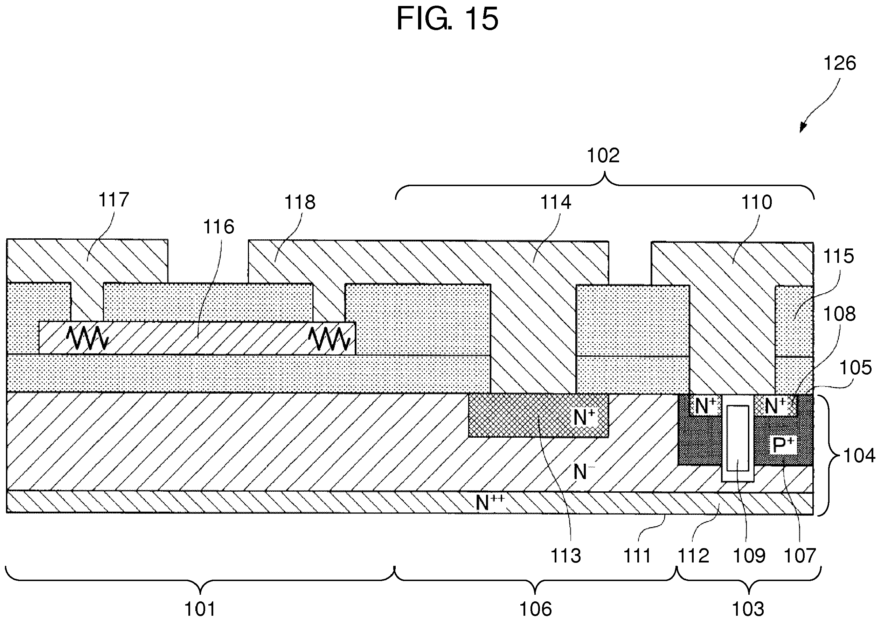

First, the semiconductor device and the method of manufacturing the semiconductor device according to a second exemplary embodiment will be described with reference to FIGS. 15 to 17.

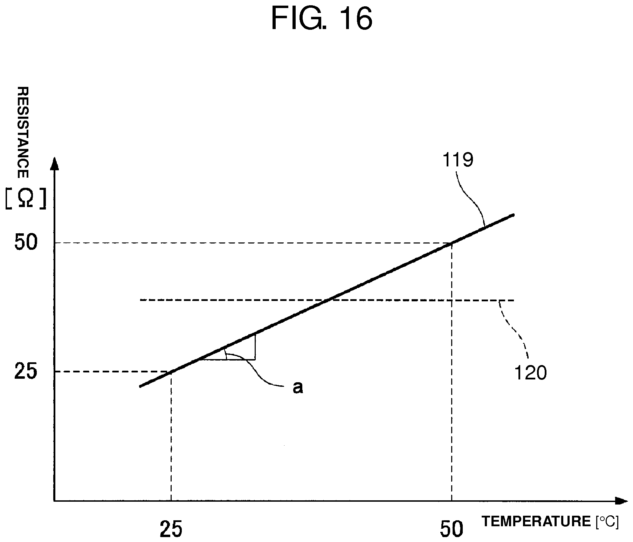

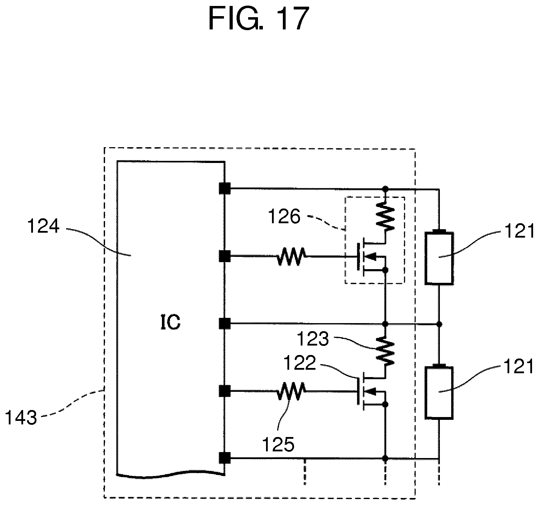

FIG. 15 is a sectional view of a configuration of the semiconductor device according to the second exemplary embodiment. FIG. 16 is a diagram illustrating temperature dependency of the resistance of the discharge resistor of the present invention, and FIG. 17 is a diagram illustrating a configuration of the cell balance circuit according to the second exemplary embodiment.

As illustrated in FIG. 15, semiconductor device 126 according to the second exemplary embodiment includes discharge resistor unit 101 and semiconductor element unit 102. Semiconductor element unit 102 includes MOSFET unit 103 included in a vertical MOSFET and drain extending unit 106 for extending a drain of the MOSFET to surface 105 of semiconductor substrate 104 on which the MOSFET is formed.

MOSFET unit 103 includes P-type diffusion layer 107 formed as a body on part of surface 105 of N-type semiconductor substrate 104, N-type diffusion layer 108 formed as a source on part of surface 105 of N-type semiconductor substrate 104 in P-type diffusion layer 107, and gate trench 109 penetrating N-type diffusion layer 108 and P-type diffusion layer 107 from surface 105 of semiconductor substrate 104. N-type diffusion layer 108 is conducted with source terminal 110 formed on surface 105 of semiconductor substrate 104. Gate trench 109 is formed on surface 105 of semiconductor substrate 104 and conducted with a gate terminal (not illustrated) formed insulating from source terminal 110. High-concentration N-type diffusion layer 112 is formed on back surface 111 opposite to surface 105 of semiconductor substrate 104.

Drain extending unit 106 is formed in a region of N-type semiconductor substrate 104 adjacent to MOSFET unit 103. In drain extending unit 106, N-type diffusion layer 113 is formed at least part of surface 105 of N-type semiconductor substrate 104. In drain extending unit 106, an electron flowing from source terminal 110 to N-type semiconductor substrate 104 through N-type diffusion layer 108 and P-type diffusion layer 107 in MOSFET unit 103 is moved to surface 105 of semiconductor substrate 104 through high-concentration N-type diffusion layer 112, N-type semiconductor substrate 104, and N-type diffusion layer 113. N-type diffusion layer 113 is conducted with drain terminal 114 formed on surface 105 of semiconductor substrate 104. Source terminal 110, the gate terminal (not illustrated), and drain terminal 114 are insulated from each other by insulating film 115 on surface 105 of N-type semiconductor substrate 104 and extended to insulating film 115.

MOSFET unit 103 and drain extending unit 106 with such a configuration serve as semiconductor element unit 102.

Discharge resistor unit 101 is formed in a region of N-type semiconductor substrate 104 adjacent to semiconductor element unit 102, preferably in a region adjacent to drain extending unit 106. In discharge resistor unit 101, resistance region 116 made of polysilicon is formed in insulating film 115 on surface 105 of N-type semiconductor substrate 104. Both ends of resistance region 116 are connected with resistance terminal 117 and resistance terminal 118 formed on insulating film 115.

The present invention has such a characteristic that impurity ions are implanted into resistance region 116 to provide a positive temperature dependency to a resistance of polysilicon of resistance region 116 as indicated by line 119 illustrating a temperature-resistance relation in FIG. 16. A gradient a of the positive temperature dependency can be determined by adjusting any one of or a combination of a kind of the impurity ions implanted into polysilicon, an acceleration energy of the impurity ions, an implantation dose amount of the impurity ions, an annealing temperature of annealing performed after the implantation of the impurity ions, and atmosphere at annealing. As indicated by line 120 illustrating a temperature-resistance relation, the resistance of typical polysilicon is almost constant independently from a temperature, or has a negative temperature dependency that the resistance decreases with increase in the temperature. In the present invention, for example, the implantation of the impurity ions into polysilicon provides the resistance with a positive temperature dependency so that the discharge resistor can have a small resistance at low temperature and have a high resistance at high temperature. Thus, the low resistance of the discharge resistor at low temperature leads to an increase in the discharge current to achieve improved discharging efficiency. On the other hand, the high resistance at high temperature leads to a reduction in the generated heat amount to prevent a high temperature of the circuit.

For example, first, P-type diffusion layer 107, N-type diffusion layer 108, gate trench 109, high-concentration N-type diffusion layer 112, and N-type diffusion layer 113 are formed on N-type semiconductor substrate 104, and then part of insulating film 115 is formed on surface 105. Thereafter, resistance region 116 of polysilicon having a thickness ranging from 100 nm to 500 nm inclusive is formed on the part of insulating film 115 of discharge resistor unit 101. Next, boron ions are implanted into resistance region 116 at a dose amount ranging from $5 \times 10^{15}$ /cm$^2$ to $5 \times 10^{16}$ /cm$^2$ inclusive. Next, a remaining part of insulating film 115 is formed. Lastly, selective etching is performed on insulating film 115, and then source terminal 110, the gate terminal (not illustrated), drain terminal 114, resistance terminal 117, and resistance terminal 118 are formed. In the formation, drain terminal 114 and resistance terminal 118 are conducted with each other. It is preferable that polysilicon has a thin film thickness as possible, for example, of 300 nm or smaller, and boron ions are implanted at a dose amount of $1 \times 10^{16}$ /cm$^2$.

As described above, the implantation of boron ions provides a positive temperature dependency to the resistance of polysilicon in resistance region 116, achieving resistance R1 of 25 Ω at a surrounding temperature of 25°C, and resistance R2 of 50 Ω at surrounding temperature of 75°C. Thus, electric power consumption P at low temperature such as the surrounding temperature of 25°C is calculated to be $P = IV = V^2/R1 = 5^2/25 = 1$ [W] for battery voltage V of 5 V. Electric power consumption P at high temperature such as the surrounding temperature of 75°C is calculated to be $P = IV = V^2/R2 = 5^2/50$

= 0.5 [W] for battery voltage V of 5 V. Accordingly, the resistance is low at low temperature, achieving a high electric power consumption and thus high discharging efficiency. In contrast, the resistance is high at high temperature, achieving a low electric power consumption and thus reduced heat generation.

The above-described configuration of the cell balance circuit of the semiconductor device will be described with reference to FIG. 17.

As illustrated in FIG. 17, in a charging circuit configured to charge a plurality of batteries 121 connected in series, MOSFET 122 is disposed in parallel with each battery 121. Discharge resistor 123 is connected in series with a drain of each MOSFET 122. In addition, an output of control circuit 124 is connected with a gate of MOSFET 122 in a one-to-one relation. Chip resistance 125 configured to remove noise and prevent instantaneous current may be provided between the gate and control circuit 124. Control circuit 124 monitors voltages of batteries 121, and if the voltage of any one of batteries 121 exceeds a predetermined voltage, stops charging and outputs an enable signal to MOSFET 122 connected with battery 121 having a voltage exceeding the predetermined voltage so as to discharge only this battery 121. In such a charging circuit, MOSFET 122, discharge resistor 123, control circuit 124, and chip resistance 125 if necessary serve as cell balance circuit 143.

When one battery 121 is charged up to a predetermined voltage such as 5 V, cell balance circuit 143 with such a configuration stops the charging and turns on MOSFET 122 connected with this battery 121 under control of control circuit 124 to discharge this battery 121 to a constant voltage such as 4.5 V. After battery 121 is discharged to 4.5 V, cell balance circuit 143 turns off this MOSFET 122 to stop the discharging and resumes charging of batteries 121 connected in series. This operation repeated until all batteries 121 are charged to 5 V. In this manner, all batteries 121 can be charged to 5 V while being prevented from overcharge.

As illustrated in FIG. 15, semiconductor device 126 according to the second exemplary embodiment is configured as an integration of MOSFET 122 and discharge resistor 123, and semiconductor element unit 102 corresponds to MOSFET 122. This integration of MOSFET 122 and discharge resistor 123 can achieve a reduction in the number of components and hence in the mounting area, facilitating mounting of cell balance circuit 143 and achieving improved quality guarantee of the components. For example, if 100 battery cells are provided to a power source, such as a motor drive power source of an automobile, on which a large number of battery cells are mounted, 200 components in total of 100 of MOSFETs 122 and 100 of discharge resistors 123 are needed. The integration of MOSFET 122 and discharge resistor 123 can reduce the number of components to 100.

As described above, the resistance of discharge resistor 123 can have a positive temperature dependency such that a low resistance at low temperature leads to high electric power consumption and hence high discharging efficiency, and a high resistance at high temperature leads to low electric power consumption and hence low heat generation.

THIRD EXEMPLARY EMBODIMENT

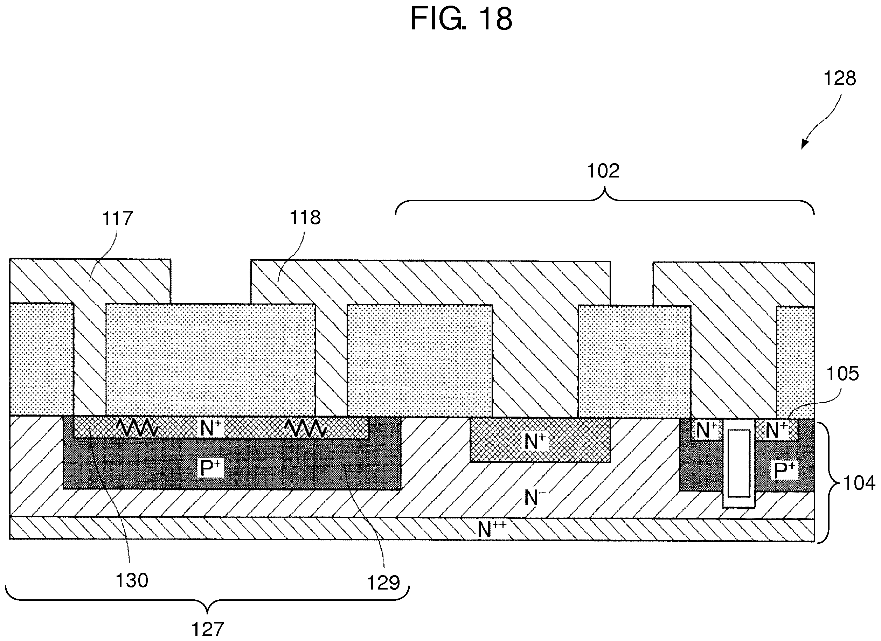

The following describes a semiconductor device according to a third exemplary embodiment and a method of manufacturing the semiconductor device with reference to FIG. 18.

FIG. 18 is a sectional view of a configuration of the semiconductor device according to the third exemplary embodiment.

Although the discharge resistor is made of polysilicon in the semiconductor device according to the second exemplary embodiment, the discharge resistor is a diffusion resistor of a diffusion layer formed on a semiconductor substrate in the semiconductor device according to the third exemplary embodiment.

As illustrated in FIG. 18, in semiconductor device 128 according to the third exemplary embodiment, semiconductor element unit 102 has the same configuration as a configuration of semiconductor element unit 102 in the semiconductor device according to the second exemplary embodiment, and thus description thereof will be omitted. In discharge resistor unit 127, P-type diffusion layer 129 is formed on at least part of surface 105 of semiconductor substrate 104, and N-type diffusion layer 130 is formed on at least part of surface 105 of semiconductor substrate 104 in P-type diffusion layer 129. Then, both end parts of N-type diffusion layer 130 are conducted with resistance terminal 117 and resistance terminal 118. N-type diffusion layer 130 serves as a resistance region.

In the semiconductor device with such a configuration, a positive temperature dependency of a resistance of N-type diffusion layer 130 can be adjusted by adjusting an impurity concentration of N-type diffusion layer 130 as a resistance region. The resistance of N-type diffusion layer 130 as the discharge resistor can have a positive temperature dependency such that a low resistance at low temperature leads to high electric power consumption and hence high discharging efficiency, and a high resistance at high temperature leads to low electric power consumption and hence low heat generation.

Similarly to the second exemplary embodiment, semiconductor element unit 102 and discharge resistor unit 127 of semiconductor device 128 according to the third exemplary embodiment correspond to the integration of MOSFET 122 and discharge resistor 123 in FIG. 17. Accordingly, similarly to the first exemplary embodiment, reduction is achieved in the number of components and hence in the mounting area. Accordingly, this facilitates mounting of the cell balance circuit and achieves improved quality guarantee of the components.

FOURTH EXEMPLARY EMBODIMENT

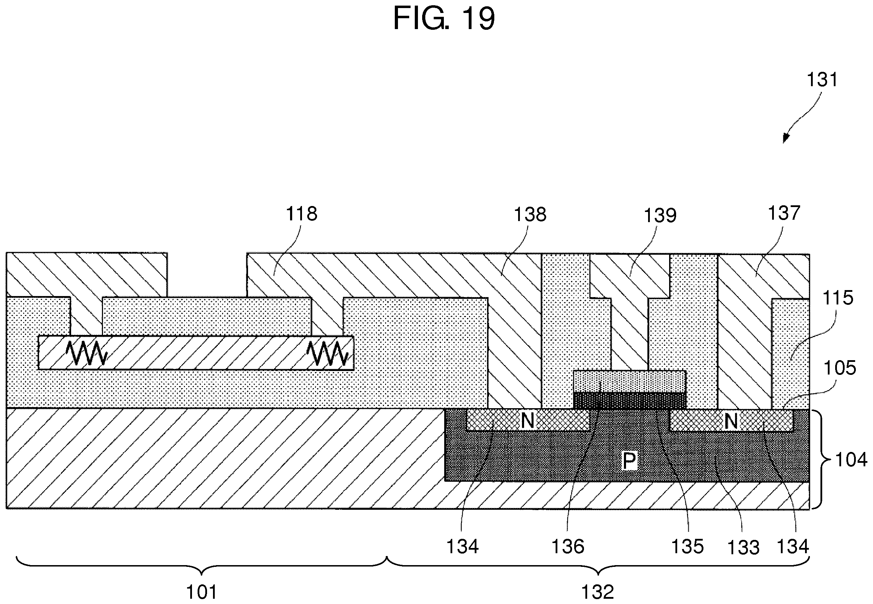

The following describes a semiconductor device according to a fourth exemplary embodiment and a method of manufacturing the semiconductor device with reference to FIG. 19.

FIG. 19 is a sectional view of a configuration of the semiconductor device according to the fourth exemplary embodiment.

Although a vertical MOSFET is used as the semiconductor element unit in the second and third exemplary embodiments, a lateral MOSFET is used in place of the vertical MOSFET in the second and third exemplary embodiments in the fourth exemplary embodiment.

As illustrated in FIG. 19, in semiconductor element unit 132 of semiconductor device 131 according to the fourth exemplary embodiment, P-type diffusion layer 133 is formed on part of surface 105 of semiconductor substrate 104, and two N-type diffusion layers 134 separated from each other are form on part of surface 105 of semiconductor substrate 104 in P-type diffusion layer 133. In addition, oxidized insulating film 135 is formed above an gap between two N-type diffusion layers 134 on surface 105 of semiconductor substrate 104, and gate metal film 136 is formed on oxidized insulating film 135. Then, source terminal 137 conducted with one of N-type diffusion layers 134, drain terminal 138 conducted with the other of N-type diffusion layers 134, and gate terminal 139 conducted with gate metal film 136 are formed to be insulated from each other by insulating film 115.

In FIG. 19, discharge resistor unit 101 is equivalent to discharge resistor unit 101 in the semiconductor device according to the second exemplary embodiment illustrated in FIG. 15, and thus description thereof will be omitted. Similarly to the first exemplary embodiment, resistance terminal 118 is conducted with drain terminal 138.

As described above, in semiconductor device 131 according to the fourth exemplary embodiment, implantation of impurity ions into polysilicon of resistance region 116 of discharge resistor unit 101 provides the resistance of the discharge resistor with a positive temperature dependency. Thus, this achieves a low resistance at low temperature and a high resistance at high temperature. Accordingly, the low resistance of the discharge resistor at low temperature leads to an increase in the discharge current. Therefore, this improves discharging efficiency. The high resistance at high temperature leads to reduction in the generated heat amount. Therefore, this prevents a high temperature of the circuit. Similarly to the first exemplary embodiment, the integration of the MOSFET and the discharge resistor leads to reduction in the number of components and hence in the mounting area. Accordingly, this facilitates mounting of the cell balance circuit and achieves improved quality guarantee of the components.

Although FIG. 19 illustrates that discharge resistor unit 101 made of polysilicon according to the first exemplary embodiment is provided as the discharge resistor unit, discharge resistor unit 127 as a diffusion resistor may be provided similarly to the second exemplary embodiment.

FIFTH EXEMPLARY EMBODIMENT

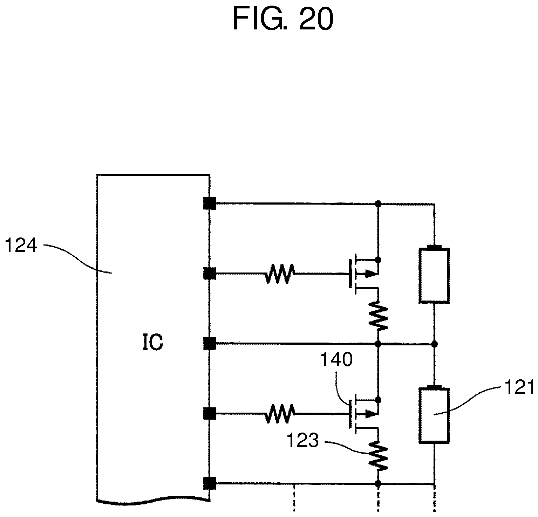

Next, an exemplary configuration of the cell balance circuit including the semiconductor device of the present invention will be described as a fifth exemplary embodiment with reference to FIG. 20.

FIG. 20 is a diagram illustrating the configuration of the cell balance circuit made of a P-channel transistor.

In the above-described second to fourth exemplary embodiments, the MOSFET in the semiconductor element unit is an N-channel MOSFET. In a semiconductor device in FIG. 20, the conduction types of the semiconductor substrate and the diffusion layer are inverted to obtain a P-channel MOSFET. In this case, too, a discharge region as the discharge resistor is connected with a drain of the MOSFET.

A charging circuit illustrated in FIG. 20 differs from the charging circuit according to the second to fourth exemplary embodiments illustrated in FIG. 17 in that MOSFET 140 is a P-channel MOSFET, and an enable signal output from control circuit 124 is at low level instead of a high level as in FIG. 17. The semiconductor device according to the present fifth exemplary embodiment is an integration of MOSFET 140 and discharge resistor 123 with the same configuration as the configuration according to the second to fourth exemplary embodiments, and the resistance of discharge resistor 123 is adjusted to have a positive temperature dependency with a predetermined gradient through this configuration.

In this manner, when MOSFET 140 is a P-channel MOSFET, the enable signal is constantly input to MOSFET 140 even at failure of control circuit 124, to discharge any battery 121. This can avoid at least overcharge of battery 121, and guarantee safety.

In the semiconductor device according to the first exemplary embodiment, similarly to the second to fifth exemplary embodiments, the resistance of the resistance film (discharge resistor) can have a positive temperature dependency. Thus, this achieves a low resistance of the discharge resistor at low temperature and a high resistance at high temperature. Accordingly, the low resistance of the discharge resistor at low temperature leads to an increase in the discharge current, thereby achieving improved discharging efficiency, and the high resistance at high temperature leads to a reduction in the generated heat amount, thereby preventing a high temperature of the circuit.

SIXTH EXEMPLARY EMBODIMENT

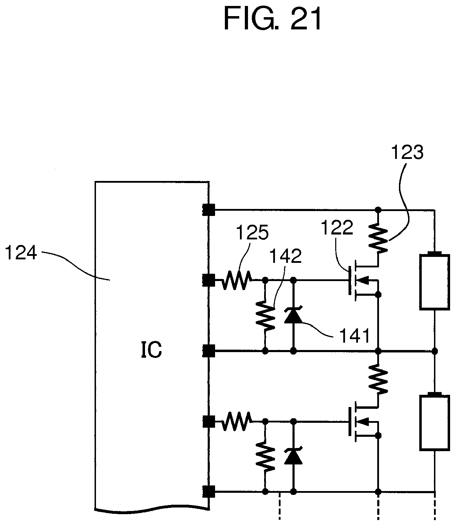

Next, an exemplary configuration of the cell balance circuit including the semiconductor device of the present invention will be described as a sixth exemplary embodiment and a seventh exemplary embodiment with reference to FIG. 21. As illustrated in FIG. 21, any one of or combination of chip resistance 125, drive diode 141, and drive resistance 142 between control circuit 124 and MOSFET 122 may be integrated into the semiconductor device together with MOSFET 122 and discharge resistor 123. This can reduce the number of connections by, for example, soldering components in the module. In particular, reduction can be achieved in a failure rate of any component mounted on an automobile requiring a higher reliability than other commercial products.

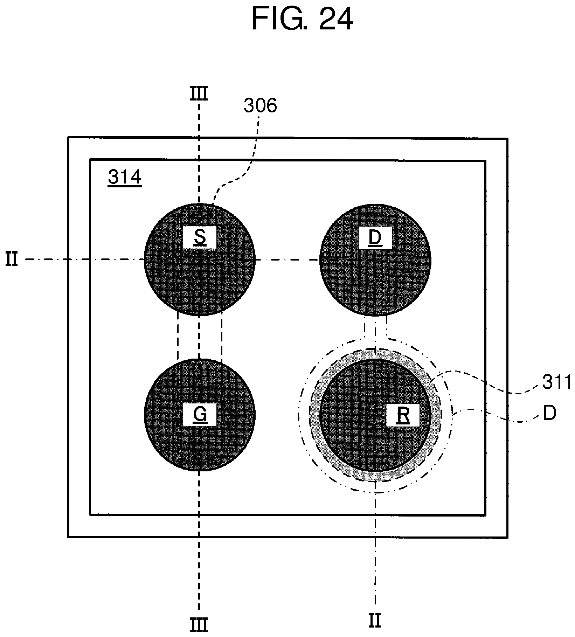

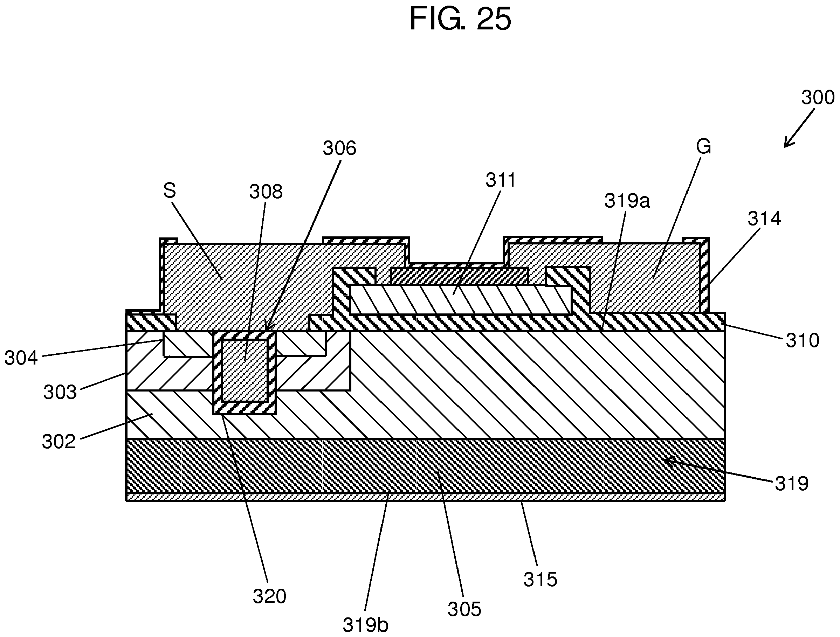

The following describes, with reference to FIGS. 24 and 25, the MOSFET semiconductor device according to the present sixth exemplary embodiment. FIG. 24 is a plan view of the MOSFET semiconductor device according to the sixth exemplary embodiment of the present invention. FIG. 25 is a sectional view taken along line III-III in FIG. 24. As illustrated in FIGS. 24 and 25, MOSFET semiconductor device 300 (hereinafter simply referred to as semiconductor device 300) according to the present sixth exemplary embodiment includes N++ semiconductor substrate 319, source electrode S, gate electrode G, drain electrode D, resistance electrode R, gate insulating film 320, insulating film 310, resistance film 311 made of polycrystalline silicon, protection film 314, and surface electrode 315. N-type epitaxial layer 302, P-type diffusion layer 303, N-type diffusion layer 304, and trench 306 are formed in N++ semiconductor substrate 319. N++ semiconductor substrate 319, source electrode S, gate electrode G, drain electrode D, and gate insulating film 320 serves as the MOSFET, which is specifically a vertical N-channel MOSFET having a trench structure.

First principal surface 319a refers to a surface of N++ semiconductor substrate 319 facing the printed wiring board when semiconductor device 300 according to the present sixth exemplary embodiment is mounted on the printed wiring board (mount substrate), and second principal surface 319b refers to a surface of N++ semiconductor substrate 319 opposite to first principal surface 319a. Source electrode S, gate electrode G, drain electrode D, and insulating film 310 are formed on first principal surface 319a of the semiconductor substrate. Resistance film 311 serving as drive resistance 226 is formed on insulating film 310, and both terminals of drive resistance 226 are connected with gate electrode G and source electrode S, respectively.

In N++ semiconductor substrate 319, N- type epitaxial layer 302, P-type diffusion layer 303, and N-type diffusion layer 304 are formed in this order in a region below source electrode S in a direction from second principal surface 319b toward first principal surface 319a. Only N- type epitaxial layer 302 is formed in a region below gate electrode G and insulating film 310. Resistance film 311 and N- type epitaxial layer 302 are electrically insulated from each other through insulating film 310.

Trench 306 is formed to extend from first principal surface 319a to N- type epitaxial layer 302 through N-type diffusion layer 304 and P-type diffusion layer 303.

Gate insulating film 320 is formed on an inner surface of trench 306, and a gate is formed further inside gate insulating film 320. In other words, the gate faces P-type diffusion layer 303 to interpose gate insulating film 320 therebetween.

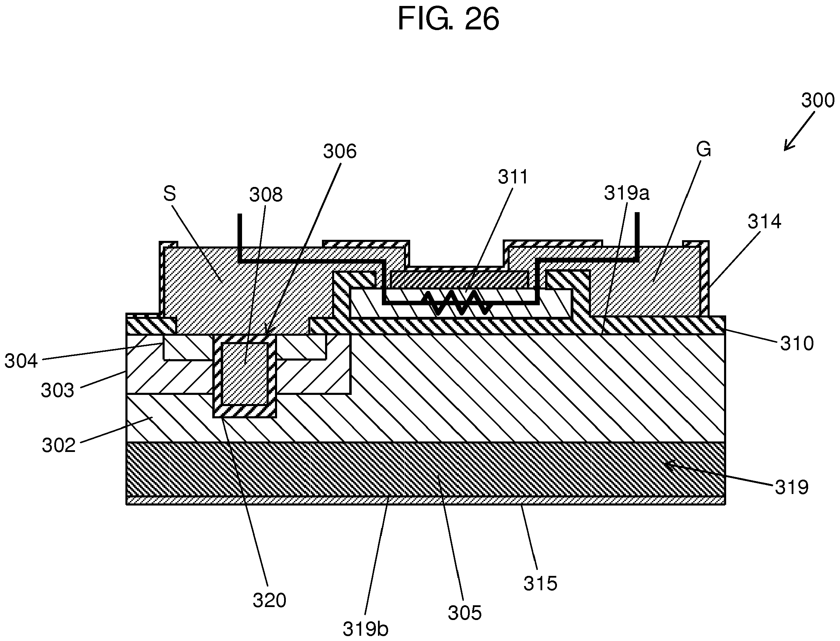

The following describes an operation of the MOSFET semiconductor device according to the present sixth exemplary embodiment with reference to FIG. 26. As illustrated in FIG. 26, when voltage is applied to gate electrode G, current flows to source electrode S through resistance film 311.

SEVENTH EXEMPLARY EMBODIMENT

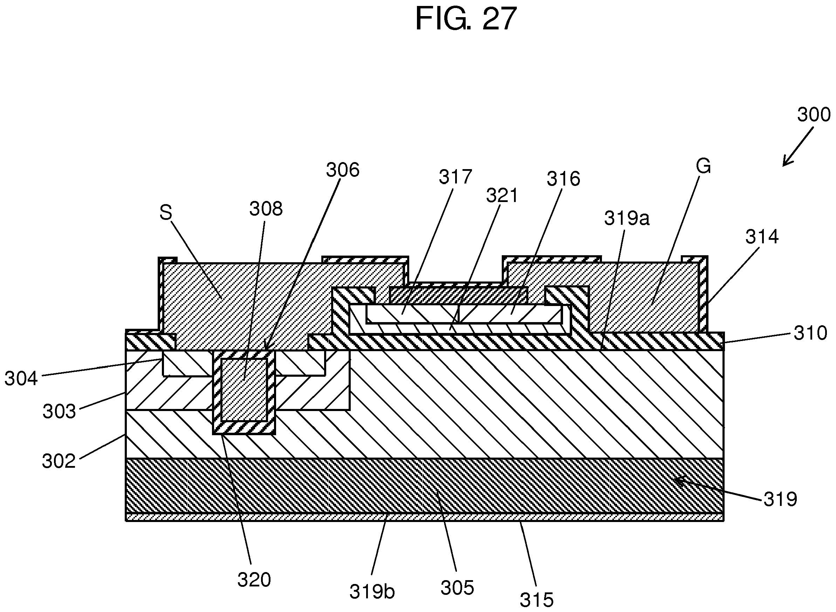

Next, an exemplary configuration of the MOSFET semiconductor device of the present invention will be described as the seventh exemplary embodiment with reference to FIG. 27. FIG. 27 is a sectional view taken along line III-III in FIG. 24. Unlike the sixth exemplary embodiment, in place of resistance film 311 on insulating film 310 in FIG. 25, polycrystalline silicon layer 321, N-type polycrystalline silicon layer 316, and P-type polycrystalline silicon layer 317 are formed on polycrystalline silicon layer 321. N-type polycrystalline silicon layer 316 and P-type polycrystalline silicon layer 317 are connected with gate electrode G and source electrode S, respectively, and formed to serve as drive diode 227.

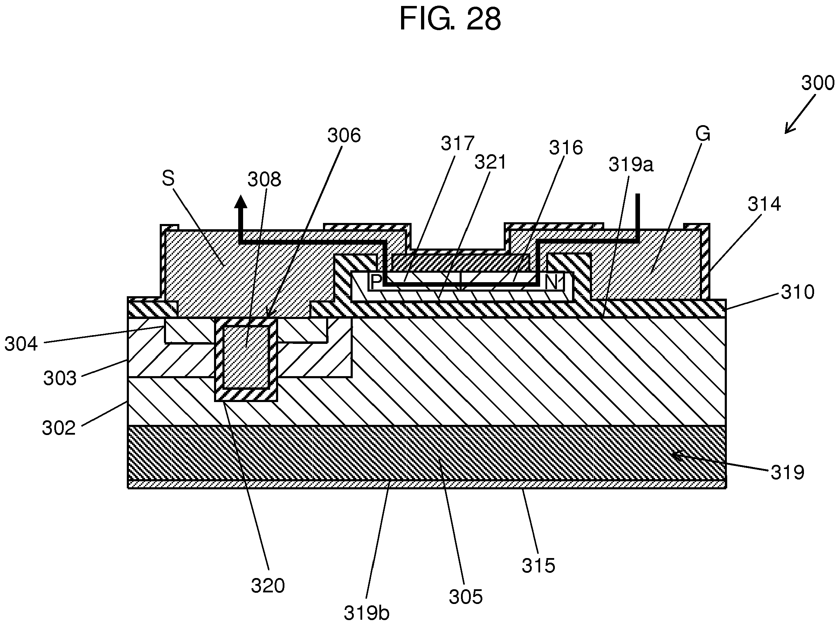

As illustrated in FIG. 28, drive diode 227 performs surge protection by allowing surge voltage applied to gate electrode G at manufacturing or mounting of semiconductor device 300 to flow to source electrode S through N-type polycrystalline silicon layer 316 and P-type polycrystalline silicon layer 317.

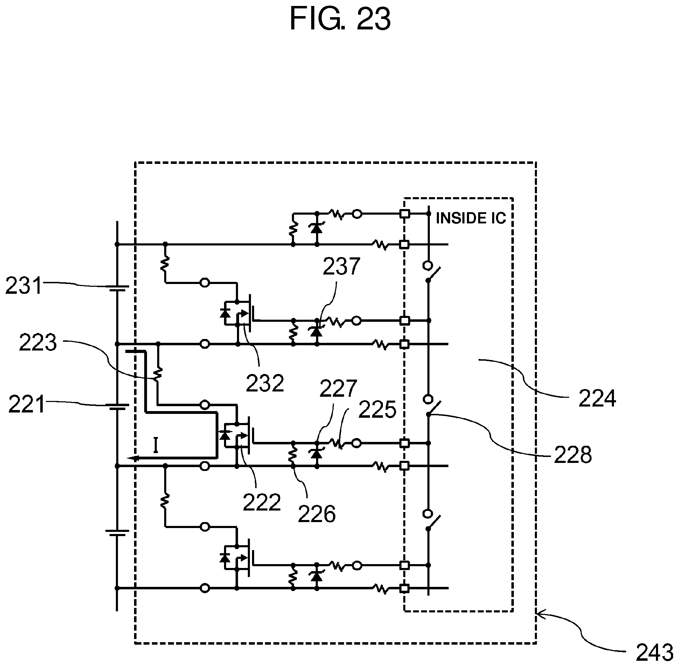

The following describes, with reference to FIG. 23, a semiconductor module on which the MOSFET semiconductor device according to the sixth exemplary embodiment and the seventh exemplary embodiment is mounted. As illustrated in FIG. 23, in a charging circuit configured to charge a plurality of batteries 221 connected in series, MOSFETs 222, 231, and the like are disposed in parallel with batteries 221, 231, and the like. Discharge resistor 223 is connected in series with a drain of each MOSFET 222. In addition, each output of control circuit 224 is connected with a gate of each of MOSFET 222, 231, and the like in a one-to-one relation. Chip resistance 225 configured to remove noise and prevent instantaneous current may further be provided between the gate and control circuit 224. Drive resistance 226 and drive diode 227 may be provided between the gate and a source.

Control circuit 224 monitors voltages of batteries 221, 231, and the like, and if the voltage of any one of batteries 221 exceeds a predetermined voltage, stops charging and outputs an enable signal to MOSFET 222 connected with battery 221 having a voltage exceeding the predetermined voltage to discharge only this battery 221. In such a charging circuit, MOSFET 222, discharge resistor 223, control circuit 224, and chip resistance 225 if necessary serve as cell balance circuit 243.

When one battery 221 is charged up to a predetermined voltage such as 5 V, cell balance circuit 243 with such a configuration stops the charging and turns on switch 228 inside control circuit 224. Accordingly, current flows from a positive terminal to a negative terminal of this charged battery 221 through drive diode 237 provided between the gate and the source of MOSFET 232 connected in parallel with battery 231 connected in series with the positive terminal, and drive resistance 226 provided between the gate and the source of MOSFET 222.

Potential of the positive terminal of charged battery 221, which was 5 V approximately, drops by a threshold voltage of drive diode 237 of 0.7 V approximately to become 4.3 V approximately, and a potential difference between the gate and the source of MOSFET 232 become -0.7 V approximately, which is not enough to turn on MOSFET 232, but a potential difference of 4.3 V, which is enough to turn on MOSFET 222, occurs between the gate and the source of MOSFET 222.

As described above, MOSFET 222 connected with battery 221 is turned on under control of control circuit 224 to discharge battery 221 to a constant voltage of, for example, 4.5 V. After battery 221 is discharged to 4.5 V, MOSFET 222 is turned off to stop the discharging, and charging of any battery 221 connected in series is resumed. This operation is repeated until all batteries 221 are charged to 5 V. In this manner, all batteries 221 can be charged to 5 V while being prevented from overcharge.

In the semiconductor device according to the sixth and seventh exemplary embodiments, similarly to the first exemplary embodiment, the resistance electrode of the semiconductor device is a surface mount terminal, and the semiconductor device is flip-mounted on the printed wiring board through a joint material. The terminal surface of the discharge resistor connected with the resistance electrode is in contact with the resistance electrode in an entire region of the terminal surface except for the terminal surface connected with the drain terminal, and the insulation surface, so as to provide a larger contact area for more efficient thermal conduction of the heat generated in the resistance film. Accordingly, the heat generated in the resistance film can be radiated to the printed wiring board through the resistance electrode.

In the semiconductor device according to the sixth and seventh exemplary embodiments, similarly to the second to fifth exemplary embodiments, the resistance of the resistance film (discharge resistor) can have a positive temperature dependency to achieve a low resistance of the discharge resistor at low temperature, and a high resistance at high temperature. Accordingly, the low resistance of the discharge resistor at low temperature leads to an increase in the discharge current to achieve improved discharging efficiency. The high resistance at high temperature leads to a reduction in the generated heat amount tp prevent a high temperature of the circuit.

INDUSTRIAL APPLICABILITY

A MOSFET semiconductor device according to the present invention can be suitably used in a charge and discharge circuit of, for example, a lithium ion battery used in a mobile phone or an electric vehicle.

The present invention is useful for, for example, a semiconductor device used for a cell balance circuit of a charging circuit configured to charge a plurality of batteries, and a method of manufacturing the semiconductor device.

REFERENCE MARKS IN THE DRAWINGS

1: MOSFET semiconductor device
10: semiconductor substrate
10a: first principal surface
10b: second principal surface
11: P-type semiconductor layer
11a: P++ silicon layer
11b: P- type epitaxially grown layer
11c: P+ diffusion layer
12: N-type diffusion layer
12a: inversion layer
13: P-type diffusion layer
14: trench
20: gate insulating film
21: insulating film
22: resistance film
23: protection film
24: metal film
S: source electrode
G: gate electrode
D: drain electrode
R: resistance electrode
I: current
B1, B2: secondary battery
101: discharge resistor unit
102: semiconductor element unit
103: MOSFET unit
104: semiconductor substrate
105: surface
106: drain extending unit
107: P-type diffusion layer
108: N-type diffusion layer
109: gate trench
110: source terminal
111: back surface
112: high-concentration N-type diffusion layer
113: N-type diffusion layer
114: drain terminal

115: insulating film
116: resistance region
117: resistance terminal
118: resistance terminal
119, 120: line illustrating temperature-resistance relation
121: battery
122: MOSFET
123: discharge resistor
124: control circuit
125: chip resistance
126: semiconductor device
127: discharge resistor unit
128: semiconductor device
129: P-type diffusion layer
130: N-type diffusion layer
131: semiconductor device
132: semiconductor element unit
133: P-type diffusion layer
134: N-type diffusion layer
135: oxidized insulating film
136: gate metal film
137: source terminal
138: drain terminal
139: gate terminal
140: MOSFET
141: drive diode
142: drive resistance
143: cell balance circuit
221: battery
222, 232: MOSFET
223: discharge resistor
224: control circuit
225: chip resistance
226: drive resistance
227: drive diode
228: switch
231: battery
237: drive diode
243: cell balance circuit
300: semiconductor device
302: N-type epitaxial layer
303: P-type diffusion layer
304: N-type diffusion layer
306: trench
310: insulating film
311: resistance film
314: protection film
315: surface electrode
316: N-type polycrystalline silicon layer
317: P-type polycrystalline silicon layer
319: N++ semiconductor substrate
319a: first principal surface
319b: second principal surface
320: gate insulating film
321: polycrystalline silicon layer
350: surface mount terminal
351: solder

352: copper wiring
360: printed wiring board
371: semiconductor substrate
372: insulating film
373: resistance film
374: insulating film
375: aluminum layer
376: nickel layer

**Claims**

1. A semiconductor device in which a discharge switch metal-oxide-semiconductor field-effect transistor (MOSFET) of a cell balance circuit used for a charging circuit configured to charge a plurality of batteries is integrated on a semiconductor substrate, the semiconductor device comprising:

  a discharge resistor integrated on the semiconductor substrate; and
  a resistance electrode integrated on the discharge resistor,

wherein

  the discharge resistor includes:

   a first terminal surface electrically connected with a drain terminal of the MOSFET;
   a second terminal surface connected with the resistance electrode; and
   an insulation surface that insulates between the first terminal surface and the second terminal surface,

  the second terminal surface is in contact with and electrically connected with the resistance electrode on an entire region of an upper surface of the discharge resistor except for the first terminal surface and the insulation surface,
  when the semiconductor device is mounted on a component mounting surface of a mount substrate on which the cell balance circuit is mounted, with an upper surface of the semiconductor device facing the component mounting surface, the resistance electrode is jointed to a terminal joint on the component mounting surface of the mount substrate through a joint material allowing electric conduction, and
  when one of the plurality of batteries is discharged, both terminals of the battery are electrically connected with the resistance electrode and a source terminal of the MOSFET, respectively, and conduction between the drain terminal and the source terminal of the MOSFET is controlled.

2. The semiconductor device according to claim 1, wherein a side surface of the second terminal surface is in contact with and electrically connected with the resistance electrode in an entire region of the side surface except for the first terminal surface and the insulation surface.

3. The semiconductor device according to claim 1, wherein the discharge resistor has a circular or polygonal shape in plan view.

4. The semiconductor device according to claim 2, wherein the discharge resistor is shaped in a circular or polygonal ring in plan view.

5. The semiconductor device according to any one of claims 1 to 4, wherein a resistance of the discharge resistor has a positive temperature dependency.

6. The semiconductor device according to claim 5, further comprising a drive resistance integrated on the semiconductor substrate,
   wherein both terminals of the drive resistance are connected with a gate terminal and the source terminal of the MOSFET, respectively.

7. The semiconductor device according to claim 6, further comprising a drive diode integrated on the semiconductor substrate,
   wherein a cathode terminal and an anode terminal of the drive diode are connected with the gate terminal and the source terminal of the MOSFET, respectively.

8. The semiconductor device according to any one of claims 1 to 7, wherein the discharge resistor is made of polysilicon implanted with impurity ions so that a resistance of the discharge resistor has a positive temperature dependency.

9. The semiconductor device according to claim 8, wherein
   the polysilicon has a film thickness ranging from 100 nm to 500 nm inclusive, and
   the impurity ions are boron ions and have a dose amount ranging from $5 \times 10^{15}$ /cm$^2$ to $5 \times 10^{16}$ /cm$^2$ inclusive.

10. The semiconductor device according to any one of claims 1 to 7, wherein the discharge resistor is a diffusion layer implanted with impurity ions so that a resistance of the discharge resistor has a positive temperature dependency.

11. The semiconductor device according to claim 10, wherein the diffusion layer is a diffusion layer of a second conduction type formed on a semiconductor substrate surface in a diffusion layer of a first conduction type formed on the semiconductor substrate surface.

12. A semiconductor device in which a discharge switch MOSFET of a cell balance circuit used for a charging circuit configured to charge a plurality of batteries is integrated on a semiconductor substrate, the semiconductor device comprising a discharge resistor integrated on the semiconductor substrate, wherein
one of terminals of the discharge resistor is connected with a drain terminal of the MOSFET,
a resistance of the discharge resistor has a positive temperature dependency, and
when one of the plurality of batteries is discharged, both terminals of the battery are electrically connected with the other terminal of the discharge resistor and a source terminal of the MOSFET, respectively, and conduction between the drain terminal and the source terminal of the MOSFET is controlled.

13. The semiconductor device according to claim 12, further comprising a drive resistance integrated on the semiconductor substrate,
wherein both terminals of the drive resistance are connected with a gate terminal and the source terminal of the MOSFET, respectively.

14. The semiconductor device according to claim 13, further comprising a drive diode integrated on the semiconductor substrate,
wherein a cathode terminal and an anode terminal of the drive diode are connected with the gate terminal and the source terminal of the MOSFET, respectively.

15. The semiconductor device according to any one of claims 12 to 14, wherein the discharge resistor is made of polysilicon implanted with impurity ions so that a resistance of the discharge resistor has a positive temperature dependency.

16. The semiconductor device according to claim 15, wherein
the polysilicon has a film thickness ranging from 100 nm to 500 nm inclusive, and
the impurity ions are boron ions and have a dose amount ranging from $5 \times 10^{15}$ /cm$^2$ to $5 \times 10^{16}$ /cm$^2$ inclusive.

17. The semiconductor device according to any one of claims 12 to 14, wherein the discharge resistor is a diffusion layer implanted with impurity ions so that a resistance of the discharge resistor has a positive temperature dependency.

18. The semiconductor device according to claim 17, wherein the diffusion layer is a diffusion layer of a second conduction type formed on a semiconductor substrate surface in a diffusion layer of a first conduction type formed on the semiconductor substrate surface.

19. A semiconductor module comprising the semiconductor device according to any one of claims 1 to 11 mounted on a component mounting surface of a mount substrate on which the cell balance circuit is mounted, with an upper surface of the semiconductor device facing the component mounting surface, wherein
the resistance electrode is jointed to a terminal joint on the component mounting surface of the mount substrate through a joint material allowing electric conduction, and
when one of the plurality of batteries is discharged, both terminals of the battery are electrically connected with the resistance electrode and a source terminal of the MOSFET, respectively, and conduction between the drain terminal and the source terminal of the MOSFET is controlled.

20. A semiconductor module comprising the semiconductor device according to any one of claims 12 to 18 mounted on a component mounting surface of a mount substrate on which the cell balance circuit is mounted,
wherein, when one of the plurality of batteries is discharged, both terminals of the battery are electrically connected with the other terminal of the discharge resistor and the source terminal of the MOSFET, respectively, and conduction between the drain terminal and the source terminal of the MOSFET is controlled.

EP 3 139 406 A1

## FIG. 1

EP 3 139 406 A1

# FIG. 2

# FIG. 3

# FIG. 4

# FIG. 5

EP 3 139 406 A1

# FIG. 6

# FIG. 7

# FIG. 8

EP 3 139 406 A1

FIG. 9

# FIG. 10

(a)

(b)

(c)

(d)

(e)

(f)

(g)

(h)

(i)

# FIG. 11

# FIG. 12

EP 3 139 406 A1

# FIG. 13

EP 3 139 406 A1

# FIG. 14

EP 3 139 406 A1

FIG. 15

126

115
108
105
104

110

N⁺
P⁺
107

109
103

N⁺

112
111

102

114

N⁺
106

N⁻
113

N⁺⁺

118

116

117

101

# FIG. 16

# FIG. 17

# FIG. 18

EP 3 139 406 A1

# FIG. 19

EP 3 139 406 A1

# FIG. 20

FIG. 21

# FIG. 22

# FIG. 23

# FIG. 24

# FIG. 25

EP 3 139 406 A1

# FIG. 26

EP 3 139 406 A1

# FIG. 27

EP 3 139 406 A1

# FIG. 28

EP 3 139 406 A1

## INTERNATIONAL SEARCH REPORT

| | International application No. |
|---|---|
| | PCT/JP2015/002221 |

A. CLASSIFICATION OF SUBJECT MATTER
*H01L21/8234*(2006.01)i, *H01L21/28*(2006.01)i, *H01L21/336*(2006.01)i,
*H01L21/822*(2006.01)i, *H01L27/04*(2006.01)i, *H01L27/06*(2006.01)i,
*H01L27/088*(2006.01)i, *H01L29/78*(2006.01)i, *H02J7/02*(2006.01)i
According to International Patent Classification (IPC) or to both national classification and IPC

B. FIELDS SEARCHED

Minimum documentation searched (classification system followed by classification symbols)
H01L21/8234, H01L21/28, H01L21/336, H01L21/822, H01L27/04, H01L27/06,
H01L27/088, H01L29/78, H02J7/02

Documentation searched other than minimum documentation to the extent that such documents are included in the fields searched
Jitsuyo Shinan Koho          1922-1996    Jitsuyo Shinan Toroku Koho    1996-2015
Kokai Jitsuyo Shinan Koho    1971-2015    Toroku Jitsuyo Shinan Koho    1994-2015

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | JP 2010-246225 A  (Sony Corp.),<br>28 October 2010 (28.10.2010),<br>entire text; all drawings<br>& US 2010/0253285 A1    & CN 101860066 A | 12-18,20<br>1-11,19 |
| Y | JP 2012-119577 A  (Renesas Electronics Corp.),<br>21 June 2012 (21.06.2012),<br>paragraphs [0018] to [0045]; fig. 3<br>(Family: none) | 12-18,20 |
| Y | JP 2012-222954 A  (Shindengen Electric Mfg. Co.,<br>Ltd.),<br>12 November 2012 (12.11.2012),<br>paragraphs [0019] to [0037]; fig. 2<br>(Family: none) | 13-18,20 |

☒  Further documents are listed in the continuation of Box C.          ☐  See patent family annex.

| | |
|---|---|
| *    Special categories of cited documents:<br>"A"  document defining the general state of the art which is not considered    to be of particular relevance<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search<br>    10 July 2015 (10.07.15) | Date of mailing of the international search report<br>    21 July 2015 (21.07.15) |
|---|---|
| Name and mailing address of the ISA/<br>    Japan Patent Office<br>    3-4-3,Kasumigaseki,Chiyoda-ku,<br>    Tokyo 100-8915,Japan | Authorized officer<br><br><br>Telephone No. |

Form PCT/ISA/210 (second sheet) (July 2009)

**INTERNATIONAL SEARCH REPORT**

International application No.

PCT/JP2015/002221

C (Continuation).    DOCUMENTS CONSIDERED TO BE RELEVANT

| Category* | Citation of document, with indication, where appropriate, of the relevant passages | Relevant to claim No. |
|---|---|---|
| Y | JP 2006-216607 A  (Ricoh Co., Ltd.),<br>17 August 2006 (17.08.2006),<br>paragraphs [0026] to [0069]<br>(Family: none) | 16,20 |
| Y | JP 2006-190709 A  (Mitsumi Electric Co., Ltd.),<br>20 July 2006 (20.07.2006),<br>entire text; all drawings<br>(Family: none) | 17,18,20 |
| A | JP 2013-509729 A  (Vishay-Siliconix),<br>14 March 2013 (14.03.2013),<br>entire text; all drawings<br>& US 2011/0101525 A1     & WO 2011/053880 A2<br>& EP 2802013 A1         & CN 102648517 A<br>& KR 10-2012-0118455 A | 1-20 |
| A | JP 2007-134588 A  (Sanken Electric Co., Ltd.),<br>31 May 2007 (31.05.2007),<br>entire text; all drawings<br>& US 2007/0108533 A1     & KR 10-2007-0050817 A | 1-20 |
| A | JP 2002-110542 A  (Toshiba Corp.),<br>12 April 2002 (12.04.2002),<br>fig. 7<br>(Family: none) | 1-20 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2007085847 A

**Non-patent literature cited in the description**

• Toranjisuta gijutsu(Transistor Technology). CQ Publishing Co., Ltd, 01 January 2014, 62-64